(19) Europäisches Patentamt
European Patent Office
Office européen des brevets

(11) **EP 4 450 979 A1**

(12) **DEMANDE DE BREVET EUROPEEN**

(43) Date de publication:
**23.10.2024 Bulletin 2024/43**

(21) Numéro de dépôt: **24169976.8**

(22) Date de dépôt: **12.04.2024**

(51) Classification Internationale des Brevets (IPC):
***G01R 15/26*** (2006.01)

(52) Classification Coopérative des Brevets (CPC):
**G01R 15/26**

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**GE KH MA MD TN**

(30) Priorité: **19.04.2023 FR 2303891**

(71) Demandeur: **Commissariat à l'énergie atomique et aux énergies alternatives**
**75015 Paris (FR)**

(72) Inventeur: **NIKOLOVSKI, Jean-Pierre**
**38054 GRENOBLE (FR)**

(74) Mandataire: **Cabinet Beaumont**
**4, Place Robert Schuman**
**B.P. 1529**
**38025 Grenoble Cedex 1 (FR)**

(54) **SYSTEME DE MESURE D'UN COURANT ELECTRIQUE ET DISPOSITIF DE DETECTION D'UN COURANT ELECTRIQUE POUR UN TEL SYSTEME**

(57) La présente description concerne un système (10) de mesure d'un courant électrique (I) circulant dans un élément conducteur électriquement (2) . Le système comprend un dispositif (15) de génération d'un champ magnétique dans l'élément conducteur électriquement, comprenant un support (53) et un fil conducteur électriquement (50) rigidement couplé au support et comprenant au moins une spire (52) enroulée autour du support, un dispositif de détection (60) d'ondes acoustiques à la surface de l'élément conducteur électriquement, et un dispositif de commande et d'acquisition (30) comprenant un générateur (33) configuré pour fournir au moins une impulsion de courant dans le fil conducteur électriquement et une chaîne d'acquisition pour la détection d'un signal électrique (S) fourni par le dispositif de détection.

Fig 1

**Description**

Domaine technique

La présente description concerne de façon générale la mesure de courant électrique statique ou variable dans le temps.

Technique antérieure

Pour certaines applications, il serait souhaitable de pouvoir mesurer un courant électrique statique ou variable dans le temps avec une résolution spatiale inférieure à 0,1 mm, en particulier pouvoir mesurer l'intensité et/ou le sens de circulation du courant électrique. Le courant électrique à mesurer correspond par exemple au courant électrique circulant dans une piste conductrice d'un circuit imprimé.

Un exemple de dispositif de détection d'un courant électrique disponible dans le commerce est un capteur à effet Hall. Toutefois, un tel capteur a de façon générale une précision spatiale supérieure à 0,1 mm et n'est donc pas adapté à la mesure d'un courant électrique très localisé. De plus, les capteurs à effet Hall existants ont une bande passante limitée qui ne dépasse pas 100 kHz et ne sont donc pas adaptés à la mesure d'un courant électrique à haute fréquence.

Résumé de l'invention

Un mode de réalisation pallie tout ou partie des inconvénients des dispositifs connus de détection de courant électrique et les systèmes de mesure de courant électrique comprenant de tels dispositifs.

Un objet d'un mode de réalisation est que le système de mesure de courant permette la mesure d'un courant électrique constant ou variable dans le temps avec une résolution spatiale inférieure à 0,1 mm.

Un objet d'un mode de réalisation est que le dispositif de détection de courant électrique du système de mesure de courant électrique puisse être fabriqué à coût réduit.

Un mode de réalisation prévoit un système de mesure d'un courant électrique circulant dans un élément conducteur électriquement, le système comprenant :

- un dispositif de génération d'un champ magnétique dans l'élément conducteur électriquement, comprenant un support et un fil conducteur électriquement rigidement couplé au support et comprenant au moins une spire enroulée autour du support ;
- un dispositif de détection d'ondes acoustiques à la surface de l'élément conducteur électriquement ; et
- un dispositif de commande et d'acquisition comprenant un générateur configuré pour fournir au moins une impulsion de courant dans le fil conducteur électriquement et une chaîne d'acquisition pour la détection d'un signal électrique fourni par le dispositif de détection.

Selon un mode de réalisation, le système comprend en outre un guide d'ondes acoustique ayant une base et une extrémité effilée fixée au support, et le dispositif de détection est un transducteur électroacoustique rigidement couplé à la base.

Selon un mode de réalisation, le dispositif de détection comprend un capteur de vibrations sans contact.

Selon un mode de réalisation, le dispositif de détection comprend un vibromètre laser.

Selon un mode de réalisation, le support correspond à une tige ferromagnétique, les spires étant enroulées autour de la tige ferromagnétique.

Selon un mode de réalisation, le dispositif de génération d'un champ magnétique comprend un aimant permanent.

Selon un mode de réalisation, le générateur est configuré pour fournir l'impulsion de courant dans le fil conducteur électriquement ayant une durée deux fois plus courte que la période correspondant à la fréquence de variation maximale du courant électrique circulant dans l'élément conducteur électriquement.

Selon un mode de réalisation, le dispositif de commande et d'acquisition comprend un amplificateur recevant le signal de mesure dont le gain est programmable par paliers croissants, chaque palier correspondant à une plage de variation possible de l'amplitude du courant électrique circulant dans l'élément conducteur électriquement.

Un mode de réalisation prévoit également un dispositif de détection d'un courant électrique circulant dans un élément conducteur électriquement comprenant :

- un dispositif de génération d'un champ magnétique dans l'élément conducteur électriquement, comprenant un support et un fil conducteur électriquement rigidement couplé au support et comprenant au moins une spire enroulée autour du support ;

- un guide d'ondes acoustiques ayant une base et une extrémité effilée fixée au support ; et
- un transducteur électroacoustique rigidement couplé à la base.

Selon un mode de réalisation, le dispositif comprend d'une spire à vingt spires, de préférence de deux spires à six spires.

Selon un mode de réalisation, le support correspond à une tige ferromagnétique, les spires étant enroulées autour de la tige ferromagnétique, et la tige ferromagnétique pénètre dans le guide d'ondes acoustiques par l'extrémité effilée.

Selon un mode de réalisation, l'extrémité de la tige ferromagnétique opposée au guide d'ondes acoustiques fuselé est taillée en pointe.

Selon un mode de réalisation, le dispositif comprend un aimant permanent au contact de la tige ferromagnétique logé dans le guide d'ondes acoustiques.

Selon un mode de réalisation, le guide d'ondes acoustiques s'étend selon un axe de la base vers l'extrémité effilée, la section droite du guide d'ondes acoustiques diminuant depuis la base jusqu'à l'extrémité effilée.

Selon un mode de réalisation, le transducteur électroacoustique est un transducteur électroacoustique à ondes transversales.

Selon un mode de réalisation, le guide d'ondes acoustiques a au moins en partie la forme d'un tronc de cône.

Selon un mode de réalisation, le guide d'ondes acoustiques a un angle au sommet inférieur à 15 °.

Selon un mode de réalisation, le guide d'ondes acoustiques est en un matériau non magnétique.

Selon un mode de réalisation, la température de fusion du guide d'ondes acoustiques et la température de fusion du fil conducteur électriquement sont supérieures à 1000°C.

Selon un mode de réalisation, le guide d'ondes acoustique comprend une portion en forme de disque, ayant un axe, aminci au niveau dudit axe, le support s'étendant selon ledit axe et étant relié à ladite portion au niveau dudit axe.

Selon un mode de réalisation, le transducteur électroacoustique comprend au moins demi-anneau piézoélectrique résonnant en épaisseur fixé au chant de ladite portion.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1 est une vue en coupe, partielle et schématique, d'un mode de réalisation d'un système de mesure de courant électrique ;

la figure 2 est une vue en coupe, partielle et schématique, d'un autre mode de réalisation de la sonde du système de mesure de la figure 1 ;

la figure 3 représente des courbes d'évolution du champ magnétique produit par les sondes des systèmes de mesure des figures 1 et 2 ;

la figure 4 est une vue en coupe, partielle et schématique, d'un autre mode de réalisation de la sonde du système de mesure de la figure 1 ;

la figure 5 est une vue de dessus d'un élément de la sonde de la figure 4 ;

la figure 6 est une vue en coupe, partielle et schématique, d'un autre mode de réalisation de la sonde du système de mesure de la figure 1 ;

la figure 7 est une vue en coupe, partielle et schématique, d'un autre mode de réalisation de la sonde d'un système de mesure de courant électrique ;

la figure 8 est une vue de dessous de la sonde de la figure 7 ;

la figure 9 est un schéma par blocs du système de détection de la figure 1 illustrant des modes de réalisation du dispositif de commande et d'acquisition du système de mesure de courant électrique ;

la figure 10 est une vue en coupe, partielle et schématique, d'un autre mode de réalisation d'un système de mesure de courant électrique ;

la figure 11 est une vue en coupe, partielle et schématique, d'un autre mode de réalisation du dispositif de génération de champ magnétique du système de mesure de la figure 10 ;

la figure 12 est une vue en coupe, partielle et schématique, d'un autre mode de réalisation du dispositif de génération de champ magnétique du système de mesure de la figure 10 ;

la figure 13 représenté, de façon partielle et schématique, un exemple de vibromètre laser ;

la figure 14 est un schéma d'un circuit électrique utilisé pour la réalisation d'essais ;

la figure 15, la figure 16, et la figure 17 représentent des courbes d'évolution en fonction du temps du signal de mesure fourni par le système de mesure de courant électrique de la figure 1 obtenues au cours d'essais ; et

la figure 18, la figure 19, et la figure 20 représentent des courbes d'évolution du champ magnétique engendré par la sonde du système de mesure de courant électrique obtenues au cours d'essais.

Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures ou à une sonde dans une position normale d'utilisation.

Sauf précision contraire, les expressions "environ", "approximativement", "sensiblement", et "de l'ordre de" signifient à 10 % près, de préférence à 5 % près. Dans le cas d'angle, les expressions "environ", "approximativement", "sensiblement", et "de l'ordre de" signifient à 10 ° près, de préférence à 5 ° près. En outre, on considère ici que les termes "isolant" et "conducteur" signifient respectivement "isolant électriquement" et "conducteur électriquement".

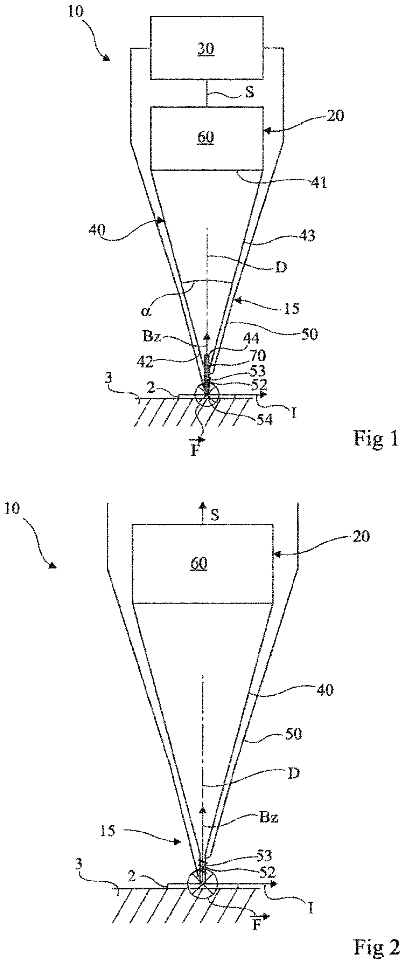

La figure 1 est une vue en coupe, partielle et schématique, d'un mode de réalisation d'un système 10 de mesure d'un courant électrique I. Le courant électrique I à mesurer correspond, par exemple, au courant électrique circulant dans une piste conductrice 2. Il s'agit par exemple d'une piste conductrice faisant partie d'un circuit imprimé 3. Le système 10 permet de mesurer l'intensité du courant I et le sens de circulation du courant I dans la piste 2.

Le système 10 comprend un dispositif 15 de génération de champ magnétique, un capteur d'ondes mécaniques 60 et un dispositif de commande et d'acquisition 30 relié au dispositif 15 de génération du champ magnétique et au capteur d'ondes mécaniques 60. Le capteur d'ondes mécaniques 60 fournit un signal S au dispositif de commande et d'acquisition 30. Le dispositif 15 de génération de champ magnétique comprend un fil conducteur électriquement 50 qui forme des spires 52 d'axe D enroulées autour d'un support 53.

Selon un mode de réalisation, le dispositif 15 de génération de champ magnétique et le capteur d'ondes mécaniques 60 font partie d'un dispositif 20 de détection d'un courant, appelé sonde par la suite, qui comprend en outre un guide 40 reliant le support 53 au capteur d'ondes mécaniques 60. Selon un mode de réalisation, le guide 40 est un guide d'ondes acoustiques 40 et le capteur d'ondes mécaniques 60 est un transducteur électroacoustique couplé au guide d'ondes acoustiques 40. L'extrémité libre du support 53 est appelée extrémité 54 de la sonde 20 par la suite.

Dans le mode de réalisation illustré en figure 1, le guide d'ondes acoustiques 40 a une forme fuselée selon l'axe D avec une section droite dont la surface diminue depuis une base 41 jusqu'à une extrémité effilée 42, opposée à la base 41, à la jonction avec le support 53 des spires 52. Le guide d'ondes acoustiques 40 est appelé guide fuselé 40 par la suite. Dans le mode de réalisation illustré en figure 1, le guide fuselé 40 comprend une ouverture cylindrique 44 d'axe D à l'extrémité effilée 42 et qui pénètre dans le guide fuselé 40 sur une partie de la hauteur du guide fuselé 40.

Selon un mode de réalisation, le guide fuselé 40 a une forme générale d'un tronc de cône, d'une pyramide tronquée, ou d'un paraboloïde tronquée. De préférence, le guide fuselé 40 présente une symétrie de révolution autour de l'axe D. Le guide fuselé 40 a un angle au sommet α inférieur à 15 °, de préférence inférieur à 10 °, plus préférentiellement inférieur à 5 °. Selon un mode de réalisation, le diamètre de la base 41 du guide fuselé 40 est dans la plage de 1 mm à 10 mm, et est de préférence égal à 5 mm. Selon un mode de réalisation, la hauteur du guide fuselé 40, mesurée selon l'axe D, est dans la plage de 5 mm à 100 mm et de préférence égale à environ 15 mm.

Le dispositif 15 de génération de champ magnétique comprend une tige 70 d'un matériau ferromagnétique qui est logée en partie dans l'ouverture 44 et qui se projette hors du guide fuselé 40. La tige ferromagnétique 70 est rigidement fixée au guide fuselé 40. La partie de la tige 70 située en dehors du guide fuselé 40 forme le support 53 des spires 52. Le fil conducteur 50 s'étend le long de la paroi latérale 43 du guide fuselé 40 et est enroulé sur la tige 70 pour former les spires 52 autour de la tige 70. Selon un mode de réalisation, la tige ferromagnétique 70 est en ferrite, par exemple ferrite douce large bande à base d'alliage NiZn ou NiMn, éventuellement recouverte d'un vernis durcisseur de protection pour éviter que la ferrite ne s'écaille.

Le diamètre de la tige ferromagnétique est dans la plage de 0,7 mm à 2 mm. Selon un mode de réalisation, la hauteur, mesurée selon l'axe D, de la tige ferromagnétique 70 logée dans l'ouverture 44 est dans la plage de 0,5 mm à 5 mm et préférentiellement égale à 1 mm. Selon un mode de réalisation, la hauteur, mesurée selon l'axe D, de la tige ferromagnétique 70 située à l'extérieur de l'ouverture 44, c'est-à-dire la hauteur du support 53 des spires 52, est dans la plage de 0,5 mm à 5 mm et préférentiellement égale à 0,5 mm. La tige ferromagnétique 70 sert de guide magnétique. Selon un mode de réalisation, l'extrémité 54 de la tige ferromagnétique 40 peut être taillée en pointe conique pour apporter le champ magnétique sur une surface infinitésimale.

La figure 2 est une vue en coupe, partielle et schématique, d'un autre mode de réalisation de la sonde 20 du système 10 de mesure d'un courant électrique. La sonde 20 représentée en figure 2 comprend l'ensemble des éléments de la sonde 20 représentée en figure 1 à la différence que la tige ferromagnétique 70 n'est pas présente, le support 53 des spires 52 correspondant alors à une tige cylindrique d'axe D prolongeant le guide fuselé 40. Le support 53 et le guide fuselé 40 peuvent correspondre à une pièce monobloc ou deux pièces distinctes fixées l'une à l'autre.

La circulation d'un courant électrique dans les spires 52 du fil conducteur 50 entraîne la génération d'un champ magnétique $\overline{\mathbf{B}}$. On appelle Bz la composante du champ magnétique $\overline{\mathbf{B}}$ selon l'axe D. L'intensité et la portée du champ magnétique engendré par les spires 52 dépend notamment du nombre de spires 52, du diamètre des spires 52, et de l'intensité du courant circulant dans les spires 52. L'intensité du champ magnétique décroit avec la distance Z à la dernière spire 52 située près de l'extrémité 54.

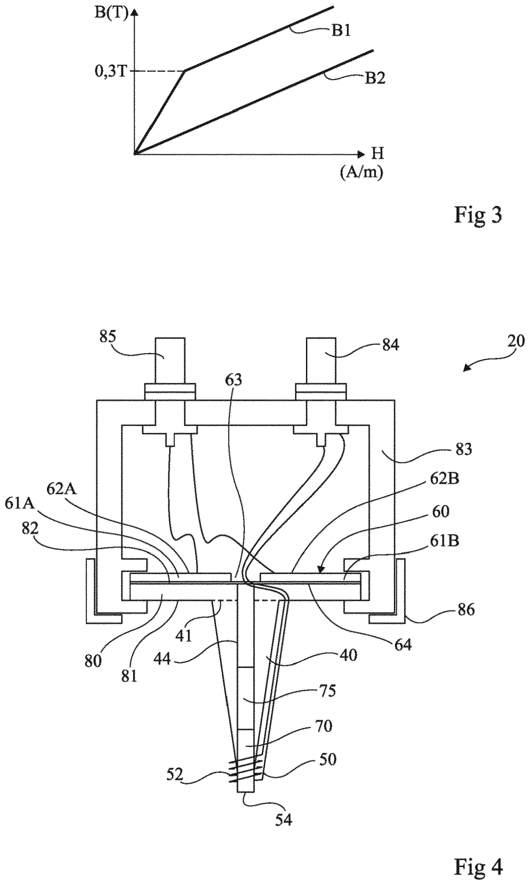

La figure 3 représente des courbes d'évolution de l'amplitude maximale B du champ magnétique produit par la sonde 20 du système de mesure de la figure 1 (courbe B1) et par la sonde 20 du système de mesure de la figure 2 (courbe B2) en fonction de l'excitation magnétique H.

Dans le mode de réalisation illustré en figure 1, lorsque que le diamètre de la tige ferromagnétique 70 est inférieur à 1 mm, le champ magnétique Bz peut localement atteindre la saturation magnétique du matériau composant la tige ferromagnétique 70, typiquement autour de 0.3T.

Dans le mode de réalisation illustré en figure 2, le diamètre des spires 52 peut être très petit, typiquement inférieur à 200 um et la composante Bz du champ magnétique peut atteindre une valeur crête impulsionnelle supérieure à 1 T, directement proportionnelle à l'intensité du courant impulsionnel crête circulant dans les spires 52.

En fonctionnement, l'extrémité 54 de la sonde 20 est placée à l'endroit où se trouve le courant I à mesurer, et est mise en contact physique directe avec le circuit imprimé 3 au niveau de la piste 2. L'axe D de la sonde 20 est agencé de préférence dans une position orthogonale au plan du circuit imprimé 3. Une tolérance de +/-10 degrés pour une mesure à 1 % est néanmoins possible sur l'inclinaison de l'axe D par rapport à la direction perpendiculaire au plan du circuit imprimé 3 dans le mesure où le signal S fourni par le transducteur électroacoustique 60 évolue en cosinus de cet angle.

Le dispositif de commande et d'acquisition 30 fait circuler un courant dans le fil conducteur 50, ce qui entraîne la génération du champ magnétique $\vec{\mathbf{B}}$ dans la piste 2 au niveau de l'extrémité 54 de la sonde 20. Lorsque l'extrémité 54 est mise en contact direct avec le circuit imprimé 3, que ce soit un contact direct avec la piste conductrice 2 ou à travers d'un vernis isolant de protection de la piste conductrice 2, les lignes de champ qui sortent de l'extrémité 54 plongent la piste 2, dans laquelle circule le courant I, dans le champ Bz.

Il en résulte une force de Lorentz F orientée dans le plan du circuit imprimé 3, dite Transverse Horizontale (TH), perpendiculairement au plan formé par la direction de la composante Bz et la direction du courant I. L'amplitude F de la force de Lorentz $\vec{\mathbf{F}}$ est définie par la relation suivante :

[Math 1]

$$F = I\Delta t V Bz$$

où V est la vitesse des électrons dans la piste conductrice 2.

Pour détecter un courant électrique I continu, il faut que le champ magnétique $\vec{B}$ soit impulsionnel, pour que la force de Lorentz $\vec{F}$ soit impulsionnelle. L'échantillonnage du courant I à mesurer est ainsi obtenu par application d'un champ magnétique $\vec{B}$ transitoire.

Selon un mode de réalisation, le dispositif de commande et d'acquisition 30 est configuré pour fournir une impulsion de courant dans le fil conducteur 50 pendant une durée d'échantillonnage Δt. Ceci entraîne la formation du champ magnétique impulsionnel $\vec{B}$ dans la piste 2 au niveau de l'extrémité 54 de la sonde 20 ayant une composante Bz selon l'axe D.

Cette force de Lorentz existe durant la durée Δt de l'impulsion de courant dans les spires 52. La force de Lorentz engendre une onde ultrasonore également de type Transverse Horizontale (TH) dans le circuit imprimé 3. L'onde ultrasonore se couple à l'extrémité 54 qui est en contact mécanique direct avec le circuit imprimé 3. L'onde ultrasonore remonte le support 53 des spires 52 sous la forme d'une onde de flexion, est transmise au guide fuselé 40, et se propage dans le guide fuselé 40, également sous la forme d'une onde de flexion, jusqu'au transducteur acoustique 60. L'amplitude de l'onde de flexion ultrasonore est notamment proportionnelle à la composante $B_z$ du champ magnétique $\vec{B}$ généré dans la piste conductrice 2, à l'intensité du courant I circulant dans la piste 2, et à la durée Δt de l'échantillonnage. L'onde de flexion est polarisée dans le sens du produit vectoriel $\vec{I}^{\wedge}\vec{B}$ perpendiculairement au plan de la figure 1 défini par l'axe D et la tangente à la piste 2. En raison de sa forme générale effilée avec un faible angle au sommet, le guide fuselé 40 favorise la propagation d'un mode acoustique de flexion engendré à l'extrémité 54 de la sonde 20 jusqu'à la base 41.

La transmission de la force de Lorentz sous forme de contrainte imposée à l'extrémité 54 de la sonde 20 correspond à une transmission d'un milieu à plus forte impédance mécanique de rayonnement vers un milieu à plus faible impédance mécanique de rayonnement. L'extrémité 54 de la sonde 20 est donc bloquée lorsqu'elle est au contact du circuit imprimé 3 et est soumise à l'impédance de rayonnement dominante de la surface en contact, en l'occurrence celle du circuit imprimé 3, même si l'impédance transversale intrinsèque (produit de la masse volumique du matériau par la vitesse des ondes transversales dans le matériau) du matériau composant principalement le circuit imprimé 3 est inférieure à celle du support 53. En effet, l'impédance de rayonnement est l'impédance intrinsèque pondérée par le volume de matière contenu dans une demi-longueur d'onde. Cette pondération est très avantageuse pour le circuit imprimé 3 en contact avec la sonde 20, très entourée de matière dans son voisinage proche (inférieur à la demi-longueur d'onde), tandis qu'elle est faible, pour l'extrémité 54 de la sonde 20 très peu entourée de matière.

Dans le mode de réalisation illustré en figure 1, la longueur de pénétration de la tige ferromagnétique 70 dans le guide fuselé 40 est réduite de façon que le couplage acoustique entre la tige ferromagnétique 70 et le guide fuselé 40 se produise sur une longueur inférieure à la demi-longueur d'onde de l'onde de flexion se propageant dans le guide fuselé 40.

L'extrémité 42 du guide fuselé 40 à la jonction avec la tige ferromagnétique 70 définit une lèvre circulaire très fine d'impédance de rayonnement inférieure ou égale à celle de la tige ferromagnétique 70 qui y est insérée. La force de Lorentz s'exerce sur une surface quasi ponctuelle et il n'y a aucune résonance acoustique d'extrémité qui pourrait venir gêner la forme d'onde, exceptée une résonance de flexion de la tige ferromagnétique 70 sur sa hauteur. Pour réduire ce risque, la hauteur de la partie de la tige ferromagnétique 70 qui n'est pas insérée dans le guide fuselé 40, c'est-à-dire la hauteur du support 53 des spires 52 de la tige ferromagnétique 70 est réduite de façon à être inférieure à une demi-longueur d'onde de l'onde de flexion qui s'y propage à la fréquence centrale de sensibilité maximale du transducteur acoustique 60.

En l'absence de résonance mécanique de l'extrémité 54 de la sonde 20, le profil de l'onde ultrasonore engendrée par la force de Lorentz est alors imposé par la bande passante du guide fuselé 40 et du transducteur électroacoustique 60. Par ailleurs, le diamètre de base 41 du guide fuselé 40 doit rester petit et comparable à la longueur d'onde pour garder une bande passante élevée. L'impédance intrinsèque du matériau constituant le guide fuselé 40 est égale au produit de la vitesse fondamentale d'une onde transversale dans le matériau par la densité du matériau. On définit l'impédance mécanique de rayonnement de l'extrémité 54 du guide fuselé 40 comme le produit de la vitesse de phase d'une onde acoustique à l'endroit du couplage par la densité du matériau constituant le guide fuselé 40. L'impédance mécanique de rayonnement est particulièrement faible, typiquement 3 à 4 fois plus faible que l'impédance intrinsèque du matériau. Cette caractéristique est avantageusement adaptée à un transfert efficace de la force de Lorentz apparaissant dans la tige 70 rigidement couplée au guide fuselé 40. L'onde acoustique atteint le transducteur électroacoustique 60 qui la convertit en un signal électrique S, par exemple une tension. Le dispositif de commande et d'acquisition 30 est configuré pour mesurer le signal électrique S fourni par le transducteur électroacoustique 60 et en déduire l'intensité I du courant circulant dans la piste 2 et le sens de circulation du courant I dans la piste 2.

La sonde 20 peut fonctionner dans deux modes de fonctionnement, un mode de fonctionnement dit passif et un mode de fonctionnement dit actif. Le mode de fonctionnement passif permet d'observer de façon asynchrone les courants de commutation circulant dans la piste conductrice 2 sur laquelle est posée la sonde 20. Dans cette configuration, la sensibilité de la sonde 20 n'est pas maîtrisée car le spectre d'excitation mécanique de la force de Lorentz dépend entièrement de la bande spectrale du courant circulant dans la piste conductrice 2. Néanmoins cette approche est intéressante pour l'observation, c'est-à-dire l'identification de signaux de courant dans une bande de fréquence assez large pouvant atteindre 80 % de la fréquence de résonance centrale du transducteur électroacoustique 60. Le mode de fonctionnement passif est bien adapté pour l'observation de commutation de courants dans une bande spectrale allant de 100 kHz à 2 MHz. Il n'y a pas de sensibilité au courant continu car une force de Lorentz continue ne se propage pas dans le guide conique et ni le transducteur piézoélectrique ni l'électronique d'amplification n'ont de sensibilité à une contrainte statique en comparaison de son pic de sensibilité à sa fréquence centrale de résonance que l'on peut choisir dans une bande qui va typiquement de 100 kHz à 5 MHz.

Le mode de fonctionnement actif exploite l'impulsion de courant circulant dans les spires, pour créer un champ magnétique Bz impulsionnel crête maîtrisé, plus intense et échantillonner avec une plus grande sensibilité un courant circulant dans la piste conductrice 2 située sous la sonde 20 à un instant prédéterminé synchrone avec un signal de synchronisation décrit plus en détail par la suite. Dans ce cas, la tige ferromagnétique 70 peut fonctionner en mode saturé. L'impulsion de courant dans les spires 52 a alors de préférence une durée inférieure ou égale à la demi-période de la fréquence centrale de résonance du transducteur électroacoustique 60. En présence d'un courant continu ou alternatif de fréquence inférieure à la moitié de la fréquence centrale du transducteur électroacoustique 60, on parvient à produire une force de Lorentz impulsionnelle calibrée dont l'amplitude est proportionnelle à l'amplitude crête du courant circulant dans la piste conductrice 2. La bande passante d'une sonde 20 étalonnée va donc du continu jusqu'à la moitié de la fréquence centrale du transducteur électroacoustique 60, soit typiquement de 0 Hz à 2 MHz.

Selon un mode de réalisation, l'intensité de l'impulsion de courant dans le fil conducteur 50 est de préférence aussi élevée que possible, en pratique entre 1 A et 100 A crête, de préférence environ entre 30 A et 50 A crête. Selon un mode de réalisation, la durée Δt de l'impulsion de courant dans le fil conducteur 50 est aussi courte que possible, par exemple entre 1 ns et 5000 ns, de préférence environ 100 ns. Dans le cas où le courant électrique à mesurer correspond à une impulsion de courant, la durée Δt est inférieure à la durée de l'impulsion de courant électrique à mesurer. Dans le cas où le courant électrique à mesurer correspond à un courant électrique sinusoïdal, la durée Δt est inférieure à au moins deux fois la période du courant électrique sinusoïdal à mesurer. De façon générale, dans le cas où le courant électrique à mesurer varie dans le temps, la durée Δt est inférieure à au moins deux fois la période correspondant à la fréquence de variation maximale du courant électrique à mesurer.

Selon un mode de réalisation, on peut enregistrer le signal associé à un courant continu et le signal associé à un courant transitoire et lorsque les deux types de courants existent, on soustrait le signal représentatif de la composante continue du signal total, le signal total étant la somme des effets du courant continu et des commutations de courant. Il ne reste alors plus que l'information de commutations. Le système de mesure 10 permet alors la mesure d'un courant électrique transitoire.

De façon avantageuse, l'encombrement latéral de l'extrémité 54 de la sonde 20 est au moins dix fois plus faible que l'encombrement latéral des sondes à effet Hall disponibles actuellement dans le commerce.

Le guide fuselé 40 introduit avantageusement un retard de propagation acoustique de 1 μs à 100 μs entre l'impulsion du champ magnétique généré à l'extrémité 54 de la sonde 20 et la fourniture du signal électrique par le transducteur électroacoustique 60. Ceci permet d'éviter le parasitage d'amplificateur de réception du dispositif de commande et de détection 30 par un couplage aérien direct entre l'impulsion du champ magnétique et l'électronique de réception.

Selon un mode de réalisation, le fil conducteur 50 a une section droite cylindrique. Selon un autre mode de réalisation, le fil conducteur 50 a une section droite qui n'est pas cylindrique. Dans ce cas, le diamètre du fil conducteur 50 est égal au diamètre du disque de même surface que la surface de la section droite du fil conducteur 50. Selon un mode de réalisation, le fil conducteur 50 a un diamètre variant de 40 μm à 200 μm, par exemple égal à environ 100 μm. Selon un mode de réalisation, le fil conducteur 50 comprend un coeur conducteur entouré d'une gaine isolante, par exemple un fil émaillé. Selon un mode de réalisation, le fil conducteur 50 forme une spire 52 à vingt spires 52, de préférence de deux spires 52 à six spires 52.

Selon un mode de réalisation, le guide fuselé 40, et le support 53 dans le mode de réalisation illustré en figure 2, est en un matériau solide non magnétique, notamment un matériau choisi dans le groupe comprenant les céramiques, les faïences, les porcelaines, les métaux non magnétiques (notamment l'aluminium, le cuivre, ou le titane), l'acier austénitique et les alliages de métaux non magnétiques, notamment les alliages à base d'aluminium, de cuivre, et/ou de titane.

Le guide fuselé 40 permet, de par sa forme géométrique effilée, de réaliser de façon avantageuse un tampon thermique entre la zone de mesure à l'extrémité 54 et une zone de réception au niveau du transducteur électroacoustique 60. La zone de mesure peut alors être portée à une température élevée de plusieurs centaines de degrés Celsius tandis que la zone de réception peut être soumise à une température plus basse compatible avec la plage de température tolérée par le transducteur électroacoustique 60.

Le transducteur acoustique 60 est configuré pour recevoir une onde acoustique et fournir un signal électrique analogique, par exemple une tension ou un courant, appelé signal de mesure par la suite. L'amplitude du signal de mesure dépend de l'amplitude de l'onde acoustique, de préférence est proportionnelle à l'amplitude de l'onde acoustique.

Le transducteur acoustique 60 reçoit un paquet et fournit un signal électrique de mesure comprenant au moins un pic, et de façon générale plusieurs pics positifs et négatifs. Le transducteur acoustique 60 peut être un transducteur acoustique à ondes transversales. Selon un mode de réalisation, le transducteur acoustique 60 est un transducteur piézoélectrique ou un transducteur acoustique électromagnétique. Le transducteur 60 correspond par exemple au transducteur piézoélectrique commercialisé par la société Olympus sous l'appellation V153 qui peut présenter une fréquence centrale autour de 1 MHz.

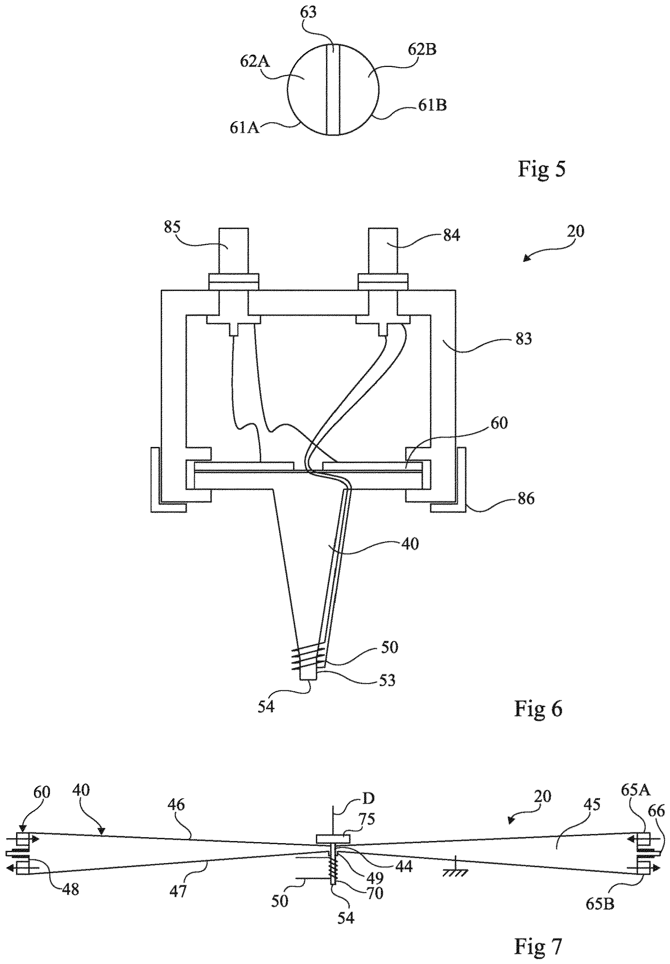

La figure 4 est une vue en coupe, partielle et schématique, d'un autre mode de réalisation de la sonde 20 du système de mesure 10 et la figure 5 est une vue de dessus d'un mode de réalisation du transducteur acoustique 60 de la sonde 20 de la figure 4.

La sonde 20 représentée en figure 4 comprend l'ensemble des éléments de la sonde 20 représentée en figure 1 et comprend, en outre, un guide d'ondes acoustiques droit 80 interposé entre le guide fuselé 40 et le transducteur électroacoustique 60. Le guide d'ondes acoustiques droit 80 a une section droite constante et s'étend de façon rectiligne et est appelé guide droit 80 par la suite. Selon un mode de réalisation, le guide droit 80 s'étend selon l'axe D et comprend deux faces opposées 81 et 82. Le transducteur électroacoustique 60 est fixé à la face 82 du guide droit 80. Selon un mode de réalisation, le guide fuselé 40 et le guide droit 80 sont des pièces distinctes. La base 41 du guide fuselé 40 est alors fixée à la face 81 du guide droit 80. Selon un autre mode de réalisation, le guide fuselé 40 et le guide droit 80 sont fabriqués d'une même pièce. La base 41 du guide fuselé 40 est alors incluse dans la face 81 du guide droit 80. Dans le mode de réalisation illustré en figure 4, le guide droit 80 a une forme cylindrique à base circulaire et la face 81 du guide droit 80 a un diamètre supérieur au diamètre de la base 41 du guide fuselé 40.

Selon un mode de réalisation, le diamètre du guide droit 80 est dans la plage de 3 mm à 7 mm, et est de préférence égal à 4 mm. L'épaisseur du guide droit 80 est dans la plage de 0,3 mm à 2 mm et est de préférence égale à environ 1 mm. Le guide droit permet de relier le transducteur électroacoustique 60 au guide fuselé 40. Le diamètre du guide droit 80 impose la fréquence de résonance radiale de flexion (typiquement 1 MHz), tout en permettant que le diamètre au niveau de la base 41 du guide fuselé 40 soit inférieur ou comparable à une longueur d'onde. Selon un mode de réalisation, la hauteur du guide fuselé 40 est dans la plage de 5 mm à 25 mm et de préférence égale à environ 10 mm.

La sonde 20 comprend, en outre, un support 83 du guide fuselé 40 fixé au guide droit 80. Selon un mode de réalisation, le support 83 est en un matériau isolant électriquement, par exemple en matière plastique, notamment un polymère. Selon un autre mode de réalisation, le support 83 est en un matériau conducteur électriquement, par exemple en métal. Le support 83 permet notamment la manipulation du guide fuselé 40. La sonde 20 comprend, en outre, un connecteur 84 fixé au support 83 et connecté aux deux extrémités du fil conducteur 50. La sonde 20 comprend, en outre, un connecteur 85 fixé au support 83 et connecté aux électrodes du transducteur acoustique 60. Une bague 86 fixée au support 83 permet de relier la sonde 20 à un système de maintien, non représenté.

Selon un mode de réalisation, l'ouverture 44 s'étend selon l'axe D sur toute la hauteur du guide fuselé 40 et éventuellement également sur toute la hauteur du guide droit 80. Un aimant permanent 75 est situé dans l'ouverture 44 dans le prolongement de la tige ferromagnétique 70 au contact de la tige ferromagnétique. L'aimant permanent 75 est par exemple réalisé en NdFeB.

Selon un premier mode de réalisation, le transducteur acoustique 60 comprend deux demi-disques 61A et 61B de céramique piézoélectrique de type PZT séparés par un petit espace 63 de largeur 0,1 mm à 0,3 mm, tandis que selon un second mode de réalisation, le transducteur est un disque en céramique PZT monolithique. Le transducteur acoustique 60 comprend, sur la face supérieure de chaque demi-disque céramique 61A, 61B, une électrodes supérieures 62A, 62B, chacune en forme d'un demi-disque. Dans la version monolithique, les deux électrodes 62A et 62B sont séparées par une bande de garde isolante, de largeur 0.1 mm à 0.3 mm. Une seule électrode inférieure 64 recouvre les faces inférieures des deux demi-disques céramiques 61A, 61B ou le disque monolithique.

Selon un mode de réalisation, l'une des électrodes supérieures 62A constitue le point chaud, tandis que l'autre électrode supérieure 62B est connectée à la masse du connecteur 85. L'électrode inférieure 64 a une tension flottante. Elle recouvre uniformément les deux demi-disques 61A, 61B qui sont des matériaux ferroélectriques dont le moment dipolaire électrique est ici orienté dans le même sens. L'électrode inférieure 64 sert à imposer un champ électrique dans l'épaisseur des demi-disques 61A, 61B. Ce champ s'inverse d'un demi-disque 61A, 61B à l'autre. Le signal de sortie S est pris entre les deux électrodes supérieures 62A, 62B. La direction de sensibilité du transducteur acoustique 60 à la polarisation acoustique de l'onde de flexion est orientée perpendiculairement à l'axe défini par l'espace 63 séparant les demi-disques 61A, 61B. L'espace 63 séparant les demi-disques 61A, 61B est donc disposé de façon parallèle à la piste conductrice 2 dans laquelle circule le courant à mesurer.

Selon un autre mode de réalisation, le moment dipolaire électrique de l'un des demi-disques 61A, 61B est inversé par rapport à l'autre. L'électrode inférieure 64 constitue la masse électrique. La détection de la polarisation de l'onde de flexion se fait également dans la direction perpendiculaire à l'axe défini par l'espace 63 séparant les demi-disques 61A, 61B. Les deux électrodes supérieures 62A et 62B sont connectées ensemble au même potentiel électrique. Le signal de sortie S est pris entre les électrodes supérieures 62A et 62B et l'électrode inférieure 64. Le montage est ainsi adapté à la détection d'une onde de flexion qui crée des contraintes mécaniques opposées sur les faces inférieures des demi-disques 61A, 61B, car les deux demi-disques 61A, 61B produiraient la même différence de potentiel entre l'électrode supérieure et la masse si les électrodes supérieures étaient distinctes. On peut donc relier les électrodes supérieures 62A et 62B entre elles pour obtenir une détection sélective d'une onde de flexion orientée perpendiculairement à l'axe défini par l'espace 63 séparant les demi-disques 61A, 61B. A titre d'exemple, le guide droit 80 et le support 83 sont conducteurs électriquement, et l'électrode inférieure 64 est collée au guide droit 80 au moyen d'une colle conductrice électriquement, par exemple une colle conductrice époxy. Le retour de masse est alors réalisé via le guide droit 80 métallique connecté au support 83 et sur lequel est vissé le connecteur 85. La fréquence de résonance d'un transducteur électroacoustique 60 en PZT à polarisation alternée d'épaisseur égale à 0,2 mm et de diamètre variant dans la plage de 4 mm à 5 mm se situe autour de 1 MHz.

La sonde 20 selon le mode de réalisation illustré sur les figures 1 et 4 sont, de façon avantageuse, plus particulièrement adaptées à la surveillance et à la détection asynchrone d'un courant électrique continu ou transitoire de courant de moyenne à forte valeur, allant de quelques dizaines de milliampères à plusieurs ampères.

La figure 6 est une vue en coupe, partielle et schématique, d'un autre mode de réalisation de la sonde 20 du système de mesure 10.

La sonde 20 représentée en figure 6 comprend l'ensemble des éléments de la sonde 20 représentée en figure 4 à la différence que l'ouverture 44, la tige ferromagnétique 70, et l'aimant permanent 75 ne sont pas présents et que le guide fuselé 40 a la forme représentée en figure 2 avec le support 53 des spires 52 correspondant alors à une tige cylindrique.

Les sondes 20 selon les modes de réalisation illustrés sur les figures 2 et 6 sont, de façon avantageuse, plus particulièrement adaptées à la détection par échantillonnage synchrone très localisé et quantifié d'un courant électrique continu ou transitoire de faible à forte valeur allant du milliampère à plusieurs ampères.

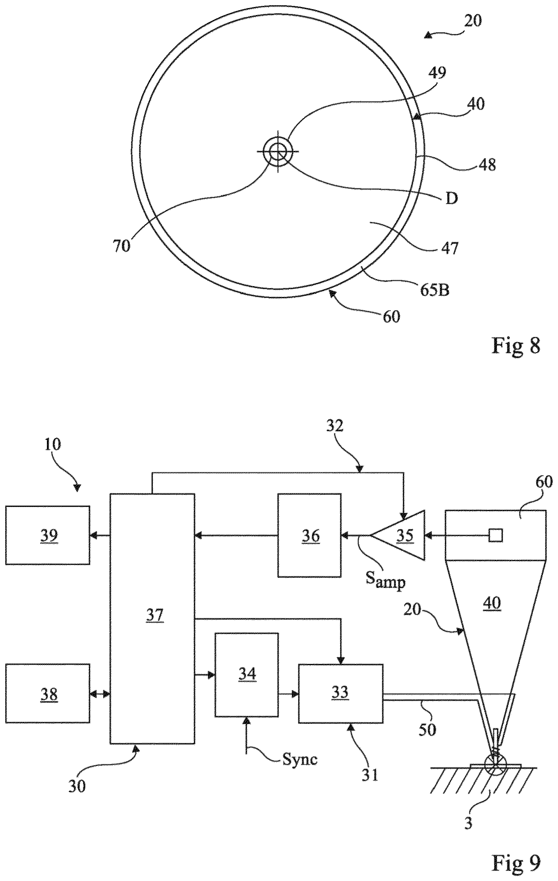

La figure 7 est une vue en coupe, partielle et schématique, d'un autre mode de réalisation de la sonde 20 du système de mesure 10 et la figure 8 est une vue de dessous de la sonde 20 de la figure 7. Dans ce mode de réalisation, le guide d'ondes 40 comprend une portion biconcave 45, par exemple biconique, à symétrie de révolution d'axe D dont l'épaisseur se réduit de la périphérie vers l'axe D. L'épaisseur maximale de la portion biconcave 45 est faible devant le diamètre de la portion biconcave 45. Selon un mode de réalisation, la portion biconcave 45 comprend une face supérieure 46 et une face inférieure 47 chacune de forme générale tronconique d'axe D et pointant l'une vers l'autre. La face supérieure 46 et la face inférieure 47 sont reliées à la périphérie de la portion biconcave 45 par un chant 48. La portion biconcave 45 du guide d'onde 40 est adaptée à résonner en épaisseur avec une polarisation perpendiculaire au chant 48.

Le guide d'ondes 40 comprend en outre une portion tubulaire 49 d'axe D se projetant depuis la face inférieure 47 de la portion biconcave 45. L'ouverture 44 s'étend dans la portion tubulaire 49 et dans la portion biconcave 45. La tige 70 est logée en partie dans l'ouverture 44 et se projette en dehors de l'ouverture 44 selon l'axe D du côté de la face inférieure 47. Comme pour les modes de réalisation représentés sur les figures 1 et 4, l'enroulement des spires 52 du fil conducteur 50 est effectué autour de la partie de la tige ferromagnétique 70 située en dehors de l'ouverture 44.

La portion biconcave 45 est inscrite dans un cylindre à base circulaire d'axe D dont le rapport entre la hauteur et le diamètre est inférieur à 5 et préférentiellement 10. A titre d'exemple, le diamètre de la portion biconcave 45 peut être compris entre 10 mm et 50 mm, par exemple égal à 20 mm de diamètre. L'épaisseur de la portion biconcave 45 au niveau du chant 48 peut être comprise entre 1 mm et 5 mm, par exemple égale à 2,7 mm. L'épaisseur de la portion biconcave 45 à l'endroit le plus mince au niveau de la liaison vers la portion tubulaire 49 peut être comprise entre 0,3 mm et 1 mm, par exemple égale à 0,4 mm. Le diamètre de l'ouverture 44, et donc le diamètre de la tige ferromagnétique 70, peut être compris entre 0,5 mm et 5 mm, par exemple égal à 0,75 mm. Le diamètre externe de la portion tubulaire 49 peut être compris entre 1 mm et 6 mm, par exemple égal à 1,2 mm. La hauteur de la tige ferromagnétique 70 est de l'ordre de 1 mm. L'extrémité 54 de la tige ferromagnétique 70 peut être taillée en pointe.

Dans le présent mode de réalisation, l'aimant permanent 75 est situé sur la face supérieure 46 de la portion biconcave 45. De façon avantageuse, les dimensions de l'aimant permanent 75 du présent mode de réalisation peuvent être supérieures aux dimensions de l'aimant permanent 75 du mode de réalisation de la sonde 20 illustré en figure 4. L'aimant permanent 75 est en contact physique direct avec la tige ferromagnétique 70. A titre d'exemple, l'aimant permanent 75 correspond à un cylindre dont le diamètre est dans la plage de 1 mm à 10 mm, de préférence de 2 mm à 3 mm, ce qui permet de disposer d'un champ magnétique statique de valeur typique 0,5 T au niveau de la face Nord ou Sud de l'aimant permanent 75 et une décroissance limitée du champ transmis à l'extrémité 54 de la tige ferromagnétique 70 de façon à ce que l'amplitude du champ magnétique produit localement au niveau de la piste 2 atteigne ou dépasse 100 mT à 300 mT.

La flexion de l'extrémité 54 de la sonde 20, sous l'effet de la force de Lorentz, se transmet sous la forme d'un basculement de l'axe de la portion tubulaire 49. Ceci engendre une onde circulaire antisymétrique par rapport au plan médian de la portion biconcave 45 du guide 40 et de type dipolaire qui se propage jusqu'au chant 48 du guide 40.

Dans le présent mode de réalisation, le transducteur acoustique 60 est situé au niveau du chant 48 de la portion biconcave 45. Le transducteur acoustique 60 comprend un demi-anneau supérieur 65A en PZT et un demi-anneau inférieur 65B en PZT disposés en vis à vis. Chaque demi-anneau 65A, 65B couvre au plus une moitié de l'épaisseur du chant 48. Chaque demi-anneau 65A, 65B a un moment dipolaire électrique polarisé en inverse par rapport à l'autre. Le positionnement des demi-anneaux 65A, 65B sur une partie du chant 48 peut être facilité par une collerette 66 de séparation du chant 48 en une portion supérieure et une portion inférieure. Les demi-anneaux 65A, 65B peuvent être fixés au guide 40 par collage. Le transducteur acoustique 60 résonne en épaisseur avec une polarisation perpendiculaire au chant 48 de la portion biconcave 45. Les demi-anneaux 65A, 65B sont connectés électriquement en parallèle et le plan de délimitation des demi-anneaux 65A, 65B passant par le centre des anneaux doit être orienté perpendiculairement à la direction de circulation du courant à mesurer. Il en résulte que le transducteur électroacoustique 60 est configuré pour détecter une onde antisymétrique de plaque, tel le mode de Lamb antisymétrique A0 qui serait principalement engendré dans un guide d'épaisseur constante. Néanmoins ici, la portion biconcave 45 du guide 40 est amincie, ce qui réduit son impédance de rayonnement au centre de la portion biconcave 45 au niveau du contact de l'extrémité 54 avec la piste 2 à sonder, de sorte que la charge mécanique de la piste 2 par l'extrémité 54 de la sonde 20 est très largement imposée par l'impédance mécanique du circuit imprimé 3. Le guide d'onde 40 constitue la masse électrique s'il est en matériau conducteur électriquement. Pour une épaisseur de 1 mm, la résonance des demi-anneaux 65A, 65B se situe autour de 1,2 MHz et le temps de transit des ondes ultrasonores entre la portion tubulaire 49 et les demi-anneaux 65A, 65B est voisin de 3,5 $\mu$s.

A titre de variante, les demi-anneaux supérieur et inférieur 65A, 65B peuvent être étendus à des anneaux complets sous réserve d'inverser la polarisation des demi-anneaux situés dans un même plan, chacun étant responsable de la détection d'une moitié de l'onde dipolaire circulaire antisymétrique qui se propage dans le guide 40. A ce moment-là, les quatre demi-anneaux peuvent être connectés en parallèle, les quatre signaux de réception étant tous en phase.

Selon un mode de réalisation simplifié, l'aimant permanent 75 peut être placé directement sous le circuit imprimé 3 à l'aplomb de la piste 2 que l'on veut sonder, c'est-à-dire du côté du circuit imprimé 3 opposé au guide 40. Ceci présente néanmoins l'inconvénient de distribuer les lignes de champ magnétique sur toute l'épaisseur du circuit imprimé 3, ce qui peut engendrer des ondes ultrasonores parasites en cas de circuit imprimé 3 multicouche.

En outre cette approche produit aussi un champ magnétique qui s'étend sur une surface latérale plus importante du circuit imprimé 3 et ne permet pas de connaître avec précision la valeur du champ magnétique au niveau de la piste 2 à sonder, sauf si l'on réalise une mesure locale au moyen d'une sonde magnétométrique.

La sonde 20 représentée sur les figures 7 et 8 permet de façon avantageuse de maximiser le champ magnétique statique au voisinage de la piste électrique 2.

La figure 9 représente un schéma par blocs du système de détection 10 illustrant un mode de réalisation du dispositif de commande et d'acquisition 30. Selon un mode de réalisation, le transducteur électroacoustique 60 est un transducteur piézoélectrique.

Le dispositif de commande et d'acquisition 30 comprend notamment une chaîne de commande 31 et une chaîne d'acquisition 32. La chaîne de commande 31 comprend :

- un générateur 33 d'impulsions de courant dans le fil conducteur 50 relié aux deux extrémités du fil conducteur 50 ; et
- un module de commande 34 du générateur d'impulsions de courant 33 recevant un signal de synchronisation Sync.

La chaîne d'acquisition 32 comprend :

- un amplificateur 35 programmable recevant le signal de mesure analogique S fourni par le transducteur électroacoustique 60 et fournissant un signal de mesure analogique amplifié $S_{amp}$ sensiblement égal au signal de mesure S multiplié par un gain d'amplification G ; et
- un module de traitement 36 recevant le signal de mesure amplifié fourni par l'amplificateur 35.

Le dispositif de commande et d'acquisition 30 comprend en outre :

- un microcontrôleur 37 relié à l'amplificateur 35, au module de traitement 36, au module de commande 34, et au générateur 33 ;
- un ordinateur 38 relié au microcontrôleur 37 ; et
- une interface homme-machine 39 reliée au microcontrôleur 37 et/ou à l'ordinateur 38 et comprenant notamment un écran d'affichage.

A titre de variante, le module de commande 34 et/ou le module de traitement 36 peuvent être intégrés au microcontrôleur 37.

Le dispositif de commande et d'acquisition 30 illustré en figure 9 est configuré pour la génération d'une impulsion de courant dans le fil conducteur 50 d'intensité Iz et de durée $\Delta$t et se produisant éventuellement après l'écoulement d'un délai T suivant une impulsion du signal de synchronisation Sync dans le cas d'une mesure synchrone.

L'ordinateur 38 est configuré pour échanger des signaux avec le microcontrôleur 37, par exemple via un port UART (sigle anglais pour Universal asynchronous receiver-transmitter), notamment les valeurs du délai T, de la durée Δt, de l'intensité I, et la valeur du gain G de l'amplificateur programmable 35.

Selon un mode de réalisation, la valeur du gain G de l'amplificateur programmable 35 est déterminée à partir de l'intensité du courant I déterminée au cours de la mesure précédente. Plus l'intensité I déterminée lors de la mesure précédente est faible, plus la valeur du gain G est grande, par exemple selon des paliers correspondant à des plages de mesure de l'intensité I.

Selon un mode de réalisation, le déclenchement du processus de mesure se produit à partir du signal de synchronisation Sync si la mesure est synchrone. Selon un autre mode de réalisation, le déclenchement du processus de mesure se produit de façon automatique et périodique avec une période de mesure définie par l'utilisateur si la mesure est asynchrone. Dans ce cas, la période de mesure est de préférence supérieure au temps d'amortissement de l'impulsion acoustique se propageant dans le guide fuselé 40 dû à l'impulsion de courant précédente.

Selon un mode de réalisation, le générateur 33 applique une impulsion de courant d'intensité Iz dans le fil conducteur 50 couplé à l'extrémité effilée 42 du guide fuselé 40 avec un délai T et une durée Δt définies dans le module de commande 34. En présence d'un courant I dans la piste conductrice 2, une onde acoustique ultrasonore remonte de l'extrémité effilée 42 vers la base 41 du guide fuselé 40. L'onde acoustique est convertie en signal électrique de mesure S par le transducteur acoustique 60 couplé à la base 41, et le signal électrique de mesure S est amplifié par l'amplificateur programmable 35 pour fournir le signal de mesure amplifié $S_{amp}$.

Selon un mode de réalisation, le module de traitement 36 est configuré pour détecter l'amplitude de crête du signal de mesure amplifié $S_{amp}$ et fournir une valeur analogique de l'amplitude crête détectée au microcontrôleur 37. Selon un mode de réalisation, le module de traitement 36 est en outre configuré pour déterminer une valeur binaire Polar I/O représentative du signe positif ou négatif de la première impulsion du signal de mesure amplifié $S_{amp}$. En effet, la phase de l'onde acoustique change de 180° selon que le courant électrique I circule dans un sens ou dans le sens opposé. Le microcontrôleur 37 peut en outre comprendre un convertisseur analogique/numérique adapté à recevoir la valeur analogique de l'amplitude crête détectée et fournir un signal numérique de l'amplitude crête.

Selon un mode de réalisation, le microcontrôleur 37 est configuré pour recevoir directement le signal de mesure amplifié $S_{amp}$ et réaliser un échantillonnage du signal de mesure amplifié $S_{amp}$, par exemple sur une profondeur de 10 à 16 bits et à une cadence de 5 à 12 méga échantillons par seconde sur une fenêtre temporelle de 1 μs à 100 μs. Selon un mode de réalisation, le microcontrôleur 37 est configuré pour réaliser une interpolation des points de mesure de façon à reconstituer finement le signal de mesure amplifié et obtenir une valeur précise de l'amplitude crête et de la phase du signal de mesure amplifié.

Selon un autre mode de réalisation, le microcontrôleur 37 est configuré pour déterminer la transformée de Fourier du signal de mesure amplifié $S_{amp}$. De préférence, la transformée de Fourier est déterminée à partir de la trace temporelle du signal de mesure amplifiée $S_{amp}$ incluant les pics du signal de mesure amplifié $S_{amp}$ et en excluant le couplage parasite de l'impulsion de courant ou de tension de sorte qu'il ne reste dans la trace temporelle que les pics dus à la réception du paquet d'ondes acoustiques par le transducteur 60 avec un signal de mesure nul avant son arrivée et après son arrivée.

Selon un mode de réalisation, le signal de mesure amplifié $S_{amp}$ est traité de façon à ce que ses valeurs soient nulles après le quatrième ou cinquième passage à zéro du signal de mesure amplifié $S_{amp}$, ce qui correspond au moment où l'essentiel du paquet d'ondes acoustiques a été reçu par le transducteur 60 et que l'on entre dans la queue du paquet d'ondes acoustiques. La raie spectrale d'amplitude maximale du spectre obtenu correspond à la fréquence centrale du paquet d'ondes acoustiques. L'amplitude de la raie spectrale est représentative de la valeur d'amplitude maximale du signal de mesure amplifié $S_{amp}$.

La détermination de l'amplitude crête du signal de mesure amplifié $S_{amp}$ à partir de la transformée de Fourier du signal de mesure amplifié $S_{amp}$ plutôt que directement à partir du signal de mesure amplifié $S_{amp}$ est plus précise et plus indépendante du bruit analogique existant au niveau du signal de mesure amplifié $S_{amp}$, ce qui permet d'accéder à des intensités de courant faibles. Dans ces cas extrêmes, la sensibilité est augmentée en remplaçant l'impulsion de courant par un train d'impulsions, comprenant par exemple 2 à 10 impulsions et préférentiellement 4 impulsions de courant équidistantes, avec une porteuse centrée sur la fréquence centrale du transducteur électromécanique 60. En outre, de façon avantageuse, la transformée de Fourier du signal de mesure amplifié $S_{amp}$ est indépendante de la durée de propagation des ondes acoustiques dans le guide fuselé 40. L'effet d'un changement de température du guide fuselé 40 se résume alors à une avance ou un retard d'arrivée du paquet d'ondes acoustiques au transducteur 60, soit simplement un changement de phase dans l'espace de Fourier.

Le microcontrôleur 37 est configuré pour déterminer l'intensité du courant électrique I en multipliant la valeur crête par un coefficient d'étalonnage. L'intensité du courant électrique I et son sens de circulation sont affichés sur l'afficheur 39 dans une unité de mesure choisie ou transmise à l'ordinateur 38 pour un traitement complémentaire. Le transducteur électroacoustique 60 est orienté de façon que la polarisation acoustique soit perpendiculaire à la piste conductrice 2 dans laquelle circule le courant électrique I à mesurer et pointe dans sa direction. On dira alors que le signal circule de gauche à droite ou de droite à gauche en fonction de la polarisation de l'onde acoustique que l'on relie aux conventions classiques de circulation du courant d'un potentiel plus élevé vers un potentiel moins élevé.

Selon un mode de réalisation, le dispositif de commande et d'acquisition 30 peut piloter une, deux, ou plus de deux sondes 20, disposées en divers endroits du circuit imprimé 3 véhiculant des signaux de courant différents, à partir du même signal de synchronisation Sync, chacune des sondes 20 pouvant être excitée avec un délai T identique ou différent par rapport aux autres sondes 20 de sorte que l'on peut multiplier l'échantillonnage spatial et temporel par le nombre de sondes 20 utilisées. Si plusieurs sondes 20 sont excitées avec des délais T légèrement différents et disposées pratiquement au même endroit d'une piste conductrice dans laquelle circule un courant électrique alternatif ou transitoire rapide, on peut multiplier le nombre de points d'échantillonnage du courant électrique par le nombre de sondes 20 utilisées.

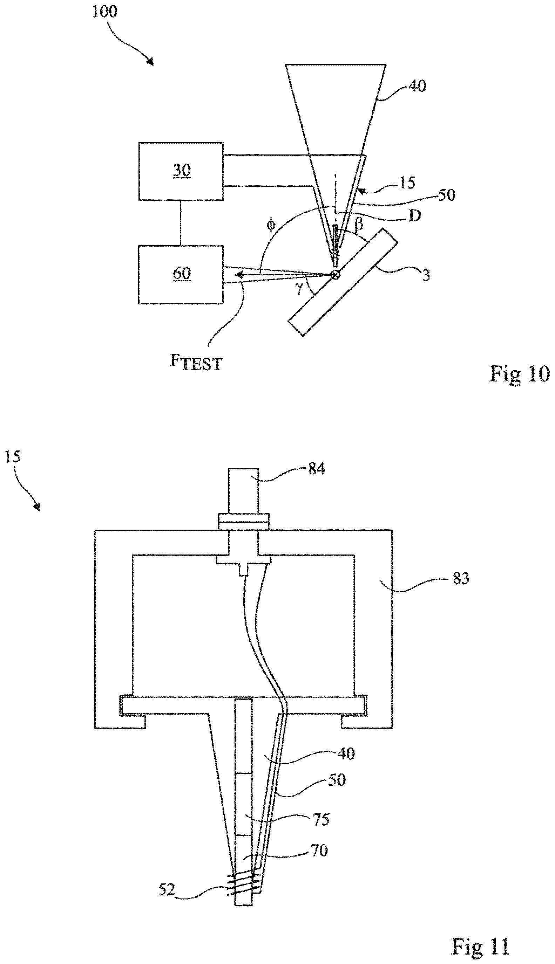

La figure 10 est une vue en coupe, partielle et schématique, d'un autre mode de réalisation d'un système de mesure de courant électrique 100. Le système de mesure de courant électrique 100 comprend l'ensemble des éléments du système de mesure de courant électrique 10 représenté en figure 1, à la différence que le capteur d'ondes mécaniques 60 est un capteur de mesure de vibrations sans contact. Le dispositif de commande et d'acquisition 30 est relié au fil conducteur 50 du dispositif 15 de génération de champ magnétique et au capteur de mesure de vibrations sans contact 60. Selon un mode de réalisation, le capteur de mesure de vibrations sans contact 60 est un vibromètre laser. Le système de mesure 100 permet de réaliser une mesure de courant électrique sans contact. En outre, la bande passante du système de mesure 100 peut être supérieure à la bande passante du système de mesure 10 représenté en figure 1.

Le procédé de génération du champ magnétique actif ou passif local est identique à ce qui a été décrit précédemment. Le vibromètre laser 60 vient réaliser une mesure de déplacement mécanique sans contact à l'endroit où le champ magnétique impulsionnel est le plus fort.

La figure 11 est une vue en coupe, partielle et schématique, d'un autre mode de réalisation du dispositif 15 de génération de champ magnétique du système de mesure 100 de la figure 10. Le dispositif 15 de génération de champ magnétique représenté en figure 11 comprend l'ensemble des éléments de la sonde 20 représentée en figure 4 à la différence que le transducteur acoustique 60 et le connecteur 85 ne sont pas présents.

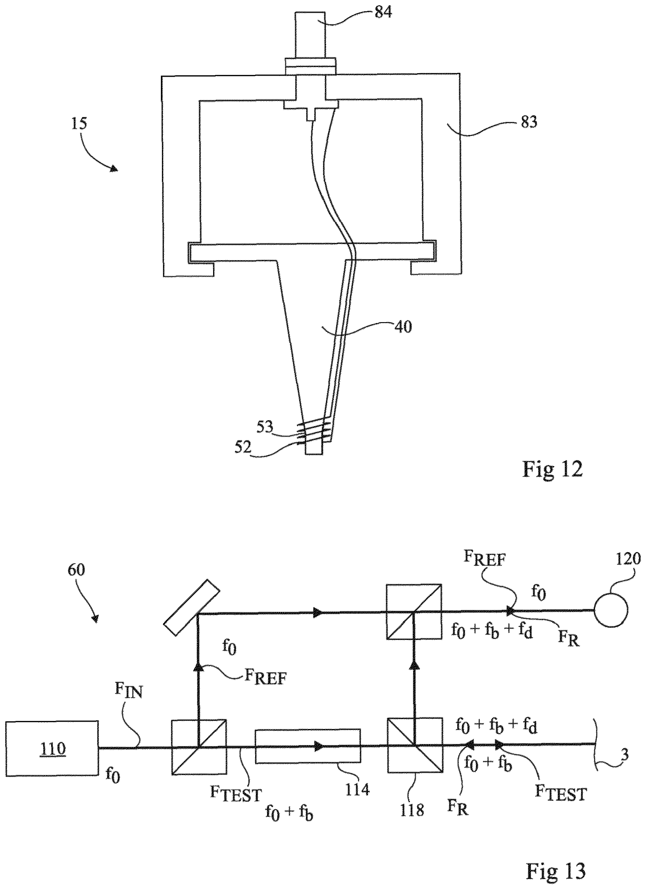

La figure 12 est une vue en coupe, partielle et schématique, d'un autre mode de réalisation du dispositif 15 de génération de champ magnétique du système de mesure 100 de la figure 10. Le dispositif 15 de génération de champ magnétique représenté en figure 12 comprend l'ensemble des éléments de la sonde 20 représentée en figure 6 à la différence que le transducteur acoustique 60 et le connecteur 85 ne sont pas présents.

Le vibromètre laser 60 permet d'effectuer des mesures de vibration sans contact de la surface du circuit imprimé 3 Le vibromètre laser 60 émet un faisceau laser $F_{TEST}$ qui est dirigé vers la surface du circuit imprimé 3 à l'endroit de la piste conductrice 2 dans laquelle circule le courant électrique à mesurer, et l'amplitude et la fréquence de vibration sont extraites du décalage Doppler de la fréquence du faisceau laser réfléchi en raison du mouvement de la surface du circuit imprimé 3. Le vibromètre laser 60 peut correspondre à un interféromètre laser à deux faisceaux qui mesure la différence de fréquence (ou de phase) entre un faisceau de référence interne et un faisceau de test. Le faisceau de test $F_{TEST}$ est dirigé vers la surface du circuit imprimé 3, et la lumière diffusée de la surface du circuit imprimé 3 est collectée et interférée avec le faisceau de référence sur un photodétecteur, par exemple une photodiode. La plupart des vibromètres commerciaux fonctionnent dans un régime hétérodyne en ajoutant un décalage de fréquence connu (généralement 30 MHz à 70 MHz) à l'un des faisceaux. Ce décalage de fréquence est généralement généré par une cellule de Bragg ou un modulateur acousto-optique.

La figure 13 est un schéma par blocs d'un mode de réalisation du vibromètre laser 60. Le vibromètre laser 60 comprend une source 110 d'un faisceau laser $F_{IN}$ à une fréquence fo. Le faisceau laser $F_{IN}$ est divisé en un faisceau de référence $F_{REF}$ et un faisceau de test $F_{TEST}$ avec un séparateur de faisceau 112. Le faisceau de test $F_{TEST}$ traverse alors la cellule de Bragg ou un modulateur acousto-optique 114, ce qui ajoute un décalage de fréquence fb. Le faisceau de test $F_{TEST}$ décalé en fréquence est ensuite dirigé vers la surface du circuit imprimé 3 à l'endroit de la piste conductrice 2 dans laquelle circule le courant électrique à mesurer. Le mouvement de la surface du circuit imprimé 3 ajoute un décalage Doppler fd au faisceau réfléchi $F_R$.

La lumière se diffuse depuis la surface du circuit imprimé 3 dans toutes les directions, mais une partie de la lumière est collectée par le vibromètre laser 60 et est réfléchie par un séparateur de faisceau 118 vers un photodétecteur 120. Cette lumière a une fréquence égale à fo + fb + fd. Cette lumière diffusée est combinée avec le faisceau de référence $F_{REF}$ au niveau du photodétecteur 120. La sortie du photodétecteur 120 est un signal S modulé en fréquence standard (FM), avec la fréquence fb comme fréquence porteuse et le décalage Doppler fd comme fréquence de modulation. Ce signal S peut être démodulé par le dispositif de commande et d'acquisition 30 pour obtenir la vitesse en fonction du temps de la surface du circuit imprimé 3.

Le vibromètre laser 60 est adapté à détecter une vibration mécanique du circuit imprimé 3 hors du plan du circuit imprimé 3. Pour obtenir une telle oscillation du circuit imprimé, l'axe D du dispositif 15 de génération de champ magnétique est incliné par rapport à la direction orthogonale au plan du circuit imprimé 3. Pour améliorer la réflexion du faisceau laser par la surface du circuit imprimé 3, celle-ci peut être localement recouverte d'un revêtement réfléchissant, par exemple une pastille adhésive de mylar métallisée réfléchissante ou de micro billes rétro-diffusantes.

En fonctionnement, le champ magnétique est appliqué sur la piste 2 à sonder. La force de Lorentz engendre un déplacement hors plan de la surface du circuit imprimé 3 au niveau de la piste 2 à sonder. Le chemin optique du faisceau laser réfléchi est modifié par la vibration ultrasonore engendrée par la force de Lorentz.

L'axe de la composante Bz du champ magnétique est incliné par rapport à la direction orthogonale au plan du circuit imprimé 3. De même, l'axe du faisceau laser de test $F_{TEST}$ est incliné par rapport à la direction orthogonale au plan du circuit imprimé 3. L'axe du champ Bz et l'axe du faisceau laser de test forment un angle $\phi$ entre eux. On appelle $\beta$ l'angle entre l'axe D et la surface du circuit imprimé 3 et $\gamma$ l'angle entre le faisceau laser de test $F_{TEST}$ et la surface du circuit imprimé 3. Le courant I que l'on veut mesurer est dans une direction perpendiculaire au plan contenant le faisceau laser $F_{TEST}$ et l'axe D. Plus l'axe D est incliné avec un angle $\beta$ faible, plus on engendre et détecte une composante de déplacement hors plan par rapport au plan du circuit imprimé 3. La méthode optique vise à détecter une composante de déplacement hors plan en faisant en sorte que l'angle $\phi$ entre le faisceau de test et le plan du circuit imprimé 3 soit proche de 90° tandis que l'angle $\beta$ est proche de 0°. Un compromis expérimental peut être trouvé avec $\beta$ valant 45° et $\gamma$ valant 90°, ce qui correspond à un faisceau laser en incidence perpendiculaire par rapport à la surface du circuit imprimé 3 et un axe du champ magnétique Bz en incidence oblique de 45°. Mais dans ce cas, il faut corriger la mesure en la multipliant par racine de deux, pour tenir compte de la diminution de l'effet Doppler lorsque $\beta$ augmente de 0 vers 90°, ici 45°correspondant à l'inclinaison de l'axe du champ Bz.

Le système de mesure de courant selon les modes de réalisation décrits précédemment permet d'identifier et de quantifier un courant électrique circulant dans un circuit en un temps très court inférieur à la microseconde. Le système de mesure de courant peut servir à la fois à isoler un signal d'intérêt dans un circuit ou encore à détecter une consommation anormale, par exemple par surveillance d'une broche d'un composant électronique, ou encore à implémenter un moyen de synchronisation avec des signaux électriques présents dans un système électronique. Le système de mesure de courant permet ainsi de repérer des zones et des instants de forte consommation de courant dans un circuit et par extension des profils de consommation de courant en des endroits particuliers d'un circuit.

Un exemple d'application des modes de réalisation du système de mesure de courant électrique décrits précédemment concerne notamment la mesure d'un courant électrique d'alimentations à découpage, qui se retrouvent très souvent dans des circuits imprimés et qui sont des sources de commutation avec des courants forts. En outre les fréquences de fonctionnement des alimentations à découpages se situent typiquement entre 50 kHz et 5 MHz avec un grand nombre de circuits qui commutent autour de 1 MHz. Ce spectre est compatible avec le mode de réalisation décrit précédemment mettant en oeuvre la sonde de courant 20 par contact ponctuel exploitant un transducteur ultrasonore à ondes transversales ainsi que les vibromètres laser les plus courants.

Un autre exemple d'application des modes de réalisation du système de mesure de courant électrique décrits précédemment concerne la mesure d'un courant électrique de broches d'alimentation de composants électroniques, en particulier les broches des composants CMS (Composants pour Montage en Surface) qui peuvent être mises en vibration ultrasonore selon un mode de flexion latéral lorsqu'un champ magnétique orthogonal au plan du circuit imprimé est appliqué. Ce type de vibration est parfaitement bien détecté par un transducteur à pointe à ondes transversales.

Un autre exemple d'application des modes de réalisation du système de mesure de courant électrique décrits précédemment concerne le suivi de la consommation en courant dans une phase de mise au point d'un circuit électronique nécessitant d'optimiser la valeur d'un composant électronique par exemple une résistance, une inductance, un transistor ou un thyristor en électronique de puissance, notamment dans un circuit à découpage ou un transistor de commutation.

Les modes de réalisation du système de mesure de champ magnétique décrits précédemment permettent d'échantillonner un courant électrique transitoire ou oscillant, de façon synchrone, et très localisé dans l'espace et également très localisé dans le temps via une période d'échantillonnage très courte. En particulier, la résolution spatiale de mesure peut être inférieure à 0,1 mm, la durée d'échantillonnage peut être inférieure à 10 ns. Il est ainsi notamment possible de quantifier de façon synchrone ou simplement détecter de façon sans contact et asynchrone des courants électriques impulsionnels de durée minimale d'environ 10 ns ou des courants électriques variables dont la fréquence maximale est de l'ordre de 100 MHz.

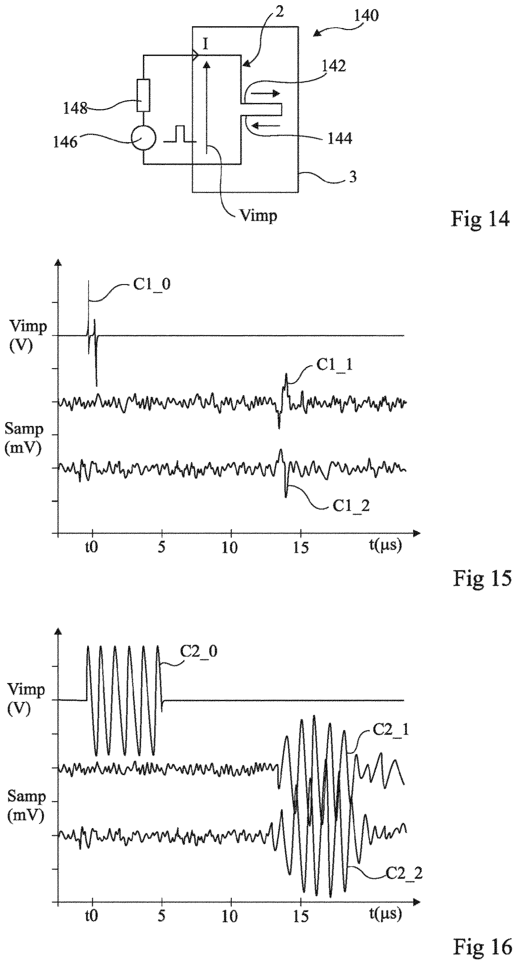

Des premier, deuxième, troisième, quatrième, cinquième, et sixième essais ont été réalisés. La figure 14 représente de façon schématique le circuit électronique 140 utilisé pour les essais. Le circuit électronique 140 comprend le circuit imprimé 3 qui est un circuit imprimé à une couche dont le substrat en matériau standard verre époxy FR4 a une épaisseur égale à 1 mm. La piste conductrice 2 à sonder du circuit imprimé 3 est recouverte d'un vernis isolant ayant une épaisseur égale à 25 um. La piste conductrice 2 est une piste en cuivre ayant une épaisseur égale à 35 $\mu$m. La piste conductrice 2 est agencée en forme en "U" comprenant deux branches formant une piste aller 142 et une piste retour 144 en série. La distance entre les deux pistes 142 et 144 du "U" est de 150 $\mu$m et les pistes aller 142 et retour 144 ont chacune une largeur de 150 um et une longueur de 10 mm. Un générateur 146 de fonction délivre une impulsion de tension rectangulaire à travers une résistance 148 de sortie de 50 Ohms. On appelle Vimp la tension appliquée aux bornes de la piste conductrice 2.

Pour tous les essais, la sonde 20 a été utilisée pour mesurer le courant circulant dans la piste 2 du circuit électronique 140 de la figure 14. La sonde 20 utilisée pour les essais correspond au mode de réalisation décrit précédemment en relation avec la figure 1. Pour les essais, l'aimant permanent 75 est placé sur la face inférieure du circuit imprimé 3. L'aimant permanent 75 est un aimant de NdFeB de forme cylindrique à base circulaire de diamètre égal à 10 mm adapté à fournir un champ magnétique Bz égal à 0,45 T, ce qui entraîne la formation d'un champ résiduel de 275m T dans la piste conductrice 2 dans laquelle circule le courant électrique 3 à mesurer, c'est à dire à une distance correspondant à l'épaisseur traversée de 1 mm du circuit imprimé 3.

Pour tous les essais, le transducteur électroacoustique 60 est le transducteur piézoélectrique commercialisé par la société Olympus sous l'appellation V153 centré sur 1 MHz. Il s'agit d'un transducteur ultrasonore à ondes transversales. Pour tous les essais, le guide fuselé 40 est en duralumin qui est un alliage à base d'aluminium (95 %), de cuivre (4 %), de magnésium (0,5 %) et de manganèse (0,5 %).

Pour tous les essais, la hauteur du guide fuselé 40, mesurée selon l'axe D, est égale à 40 mm. L'angle au sommet du guide fuselé 40 est égal à 7,8 °. Le diamètre de la base 41 du guide fuselé 40 est égale à 5,5 mm. Le transducteur électroacoustique 60 est fixé au guide fuselé 40 par collage par une colle cyanoacrylate. Le fil conducteur 50 est un fil en cuivre émaillé enroulé autour du support 53 et collé avec une résine cyanoacrylate au support 53. Le fil conducteur 50 a un diamètre égal à 100 $\mu$m. Pour tous les essais, le gain d'amplification de l'amplificateur programmable 35 est égal à 48 dB. Pour tous les essais, les signaux mesurés sont moyennés sur 16 acquisitions.

Pour tous les essais, l'impulsion de courant traversant les spires 52 du fil conducteur 50 a une durée $\Delta t$ égale à 400 ns et a une intensité I égale à 50 A. Le sonde 20 est orientée toujours dans le même sens par rapport au circuit imprimé et l'axe du guide fuselé 40 est perpendiculaire au plan du circuit imprimé 3 et la sensibilité aux ondes de flexion est dans une direction perpendiculaire à l'axe des jambes. Le temps de transit dans le guide fuselé 40 est d'environ 13 $\mu$s.

Pour les premier, deuxième, quatrième, et sixième essais, le générateur 146 délivre une impulsion de tension de valeur crête 5 Vc à travers la résistance 148 de sortie de 50 Ohms, de sorte que le courant circulant dans la piste conductrice 2 a une intensité crête égale à environ 96 mA.

Pour les premier, deuxième, et troisième essais, l'extrémité 54 de la sonde 20 est posée successivement par translation au centre de la piste aller 142 puis de la piste retour 144 du circuit électronique 140.

La figure 15 représente des courbes d'évolution C1_1 et C1_2 en fonction du temps du signal de mesure amplifié S$_{amp}$ fourni par l'amplificateur 35 du système de détection 10 pour le premier essai. La courbe C1_1 est obtenue lorsque la sonde 20 est mise au contact de la piste aller 132 et la courbe C1_2 est obtenue lorsque la sonde 20 est mise au contact de la piste retour 134. La figure 15 représente en outre une courbe C1_0 correspondant à la tension Vimp appliquée à la piste 2. Sur l'axe des ordonnées, l'échelle est 2 V/grande graduation pour la courbe C1_0 et 2 mV/grande graduation pour les courbes C1_1 et C1_2. L'instant t0 correspond à l'envoi du signal de synchronisation Sync. Dans le premier essai, le générateur 136 fournit une seule impulsion. On constate qu'il y a bien inversion de la force de Lorentz par inversion du sens du courant entre la piste aller 132 et la piste retour 134. On outre, on constate que le signal de réception reste bien large bande. Il correspond à une onde transverse horizontale (TH) engendrée au sein de la piste 2 et transmise à la pointe conique du guide fuselé 40. Le premier essai met en évidence la détection de façon quasi ponctuelle du passage d'une impulsion de courant dans une piste conductrice 132 de faible largeur située à faible distance d'une autre piste conductrice 134 de faible largeur parcourue par un courant circulant en sens contraire.

Le deuxième essai est réalisé dans les mêmes conditions que le premier essai à la différence que le générateur 136 fournit cinq impulsions successives à une fréquence centrale de 1MHz, correspondant à la fréquence de sensibilité maximale du transducteur acoustique 60.

La figure 16 représente des courbes d'évolution C2_1 et C2_2 en fonction du temps du signal de mesure amplifié S$_{amp}$ fourni par l'amplificateur 35 du système de détection 10 pour le deuxième essai. La courbe C2_1 est obtenue lorsque la sonde 20 est mise au contact de la piste aller 132 et la courbe C2_2 est obtenue lorsque la sonde 20 est mise au contact de la piste retour 134. La figure 16 représente en outre une courbe C2_0 correspondant à la tension Vimp de 200 mVc appliquée à la piste 2 dont l'impédance, environ 2,1 Ohms, est composée d'une partie inductive liée au U et une partie résistive liée au fil de cuivre et qui est une fraction de la force électromotrice de 5 Vc produite par le générateur 146. Sur l'axe des ordonnées, l'échelle est 100 mV/grande graduation pour la courbe C2_0 et 2 mV/grande graduation pour les courbes C2_1 et C2_2. On observe que chaque signal de sortie C2_1 et C2_2 reproduit assez fidèlement le train d'impulsions d'excitation. Les deux signaux de sortie C2_1 et C2_2 sont en opposition de phase, ce qui correspond à des forces de Lorentz opposées. L'amplitude crête à crête du signal de sortie est de 5,4 mV, ce qui porte la sensibilité ampérométrique de la sonde 20 à 18 mA par mV de signal de sortie pour un champ magnétique local Bz de 275 mT.

Le troisième essai est réalisé dans les mêmes conditions que le deuxième essai à la différence le générateur 146 fournit deux séries de cinq impulsions, la première série correspondant à un courant circulant dans la piste conductrice 2 ayant une intensité crête égale à 96 mA et la deuxième série correspondant à un courant circulant dans la piste conductrice 2 ayant une intensité crête égale à 192 mA.

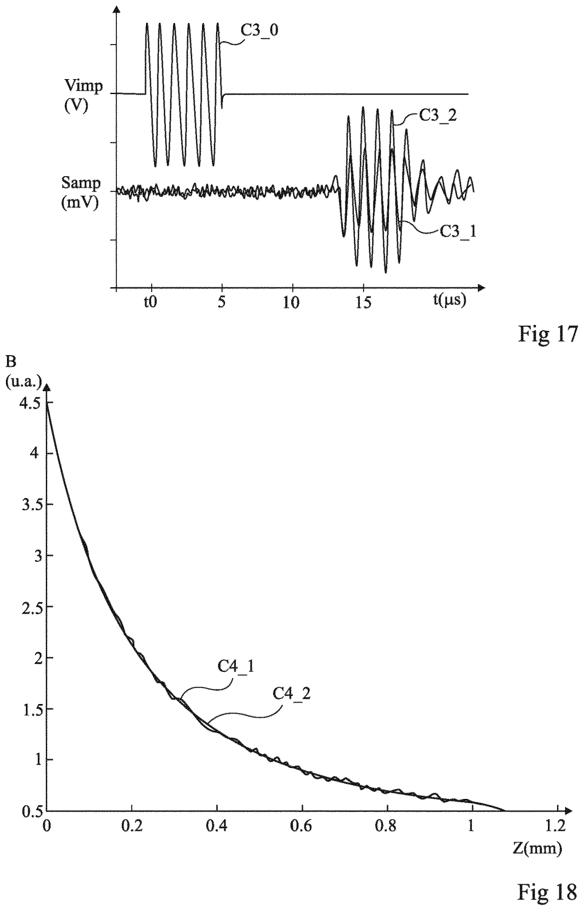

La figure 17 représente des courbes d'évolution C3_1 et C3_2 en fonction du temps du signal de mesure amplifié S$_{amp}$ fourni par l'amplificateur 35 du système de détection 10 pour le troisième essai. Les courbes C3_1 et C3_2 sont toutes les deux obtenues lorsque la sonde 20 est mise au contact de la piste aller 132 pour la première et la

EP 4 450 979 A1

deuxième série d'impulsions à la différence près que la hauteur d'impulsion du générateur 146 vaut 5 Vc pour la courbe C3_1 et 10 Vc pour la courbe C3_2. La figure 17 représente en outre une courbe C3_0 correspondant à la tension Vimp de 200 mVc associée à la courbe C3_1 et appliquée à la piste 2 pour la première série d'impulsions. Sur l'axe des ordonnées, l'échelle est 100 mV/grande graduation pour la courbe C3_0 et 2 mV/grande graduation pour les courbes C3_1 et C3_2. On observe que l'amplitude du signal de sortie passe de 5,3 mVcc pour la courbe C3_1 à 10,1 mVcc pour la courbe C3_2, ce qui aux erreurs de mesure près liées au bruit résiduel, respecte la proportionnalité entre amplitude du courant et amplitude du signal ultrasonore associé à la force de Lorentz.

Un quatrième essai est réalisé pour déterminer l'évolution du champ magnétique engendré dans l'axe D de la sonde 20 en fonction de la distance par rapport à l'extrémité de la sonde 20.

La figure 18 représente des courbes C4_1 et C4_2 de décroissance de la composante Bz du champ magnétique, en unité arbitraire, engendré dans l'axe D de la sonde 20 en fonction de la distance par rapport à la spire 52 la plus proche de l'extrémité 54 de la sonde 20. La courbe C4_1 est obtenue par essai. La courbe C4_2 est une courbe polynomiale épousant la courbe C4_1. La sonde 20 est composée de cinq spires 52 réalisées à partir d'un fil de cuivre émaillé 50 de diamètre 40 um, disposées sur le support 53 de diamètre 200 $\mu$m, l'ensemble ayant un diamètre (centre du fil à centre du fil) des spires 52 d'environ 250 $\mu$m. Le champ magnétique est mesuré par tout capteur de champ magnétique connu. La courbe C4_1 donne une indication expérimentale de la diminution du champ magnétique impulsionnel Bz en fonction de l'épaisseur du revêtement, par exemple une couche de vernis, recouvrant la piste conductrice 2. On constate que lorsque l'épaisseur de revêtement atteint environ le diamètre des spires 52, le champ magnétique est diminué sensiblement de moitié. A titre d'exemple, lorsque les spires 52 avec un diamètre 250 um, et un revêtement ayant une épaisseur de 25 um entre l'extrémité 54 de la sonde 20 et la piste de cuivre 2 crée un décalage sur la valeur du champ magnétique de 8 %, et donc de la mesure du courant. La courbe C4_2 peut être utilisée comme un abaque donnant la décroissance de la composante du champ magnétique Bz en fonction de la distance entre la piste conductrice 2 du circuit imprimé 2 et la dernière spire 52 (celle qui est le plus près du circuit imprimé) de la sonde 20.

Un cinquième essai est réalisé pour déterminer l'évolution du champ magnétique engendré dans l'axe D de la sonde 20 en présence de la tige ferromagnétique 70 et en l'absence de la tige ferromagnétique 70. Pour le cinquième essai, la tige ferromagnétique 70 est en ferrite. La tige ferromagnétique 70 est taillée en pointe par polissage à partir d'une tige de diamètre 750 $\mu$m de sorte qu'à son extrémité 54 sur laquelle sont enroulées les spires 52, le diamètre de la ferrite support 53 est de 200 $\mu$m et le diamètre des spires 52 est de 250 $\mu$m, le fil conducteur émaillé 50 ayant un diamètre de 40 $\mu$m. Pour le cinquième essai, en présence de la tige ferromagnétique 70, le fil conducteur 50 présente deux spires 52. Pour le cinquième essai, en l'absence de la tige ferromagnétique 70, le fil conducteur 50 présente cinq spires enroulées autour du support 53 qui présente un diamètre égal à 250 $\mu$m.

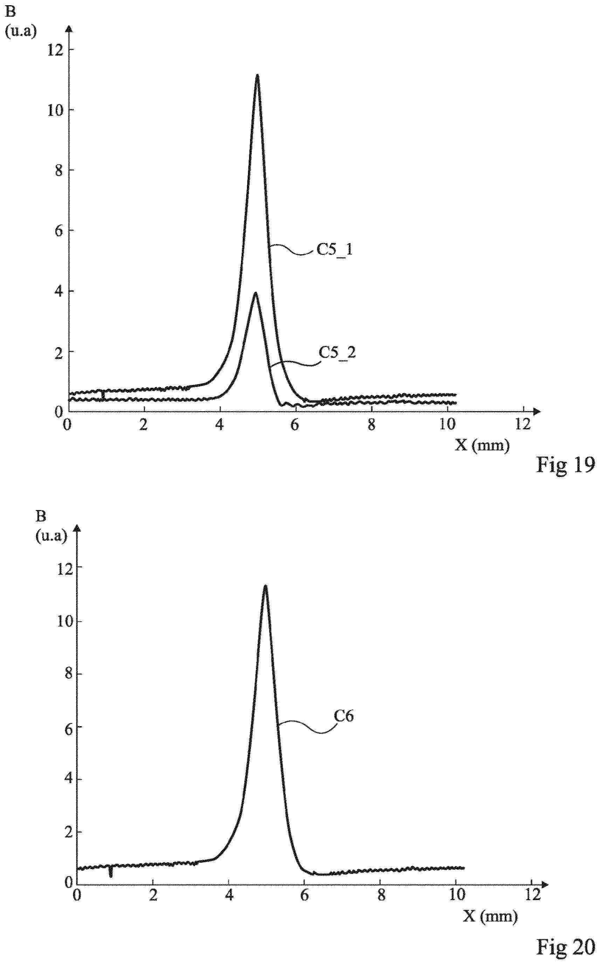

La figure 19 représente des courbes C5_1 et C5_2 d'évolution de la composante Bz du champ magnétique selon une coupe transversale parallèle au plan du circuit imprimé, en unité arbitraire, engendré à une distance fixe de 20 $\mu$m de l'extrémité 54 de la sonde 20, lorsque la sonde 20 comprend la tige ferromagnétique 70 (courbe C5_1) et lorsque la sonde 20 ne comprend pas la tige ferromagnétique 70 (courbe C5_2). Le cinquième essai met en évidence le gain apporté par l'usage de la tige ferromagnétique 70 lorsque l'on reste en dessous du seuil de saturation de la ferrite, autour de 300 mT, dans l'intensité du champ magnétique engendré à une distance donnée de l'extrémité 54 de la sonde 20, ce qui contribue à améliorer la sensibilité de la sonde 20 à courant constant circulant dans les spires 52. A induction constante, cela réduit la contrainte imposée sur le courant impulsionnel crête devant circuler dans le conducteur 50 de petit diamètre. Il apparaît que la sensibilité ampérométrique de la sonde 20 est directement proportionnelle à la perméabilité magnétique relative de la ferrite composant la tige ferromagnétique 70. Plus celle-ci est élevée et plus l'induction augmente pour un courant impulsionnel crête donné. Pour un tige ferromagnétique 70 dont le diamètre de la tige reste comparable à la longueur de la tige, la perméabilité magnétique relative multiplie par environ un facteur trois le champ magnétique local. La perméabilité magnétique relative de ce type de ferrite perdure jusqu'à une fréquence d'au moins 50 MHz. Ce n'est donc pas la bande passante de la ferrite qui est le facteur limitant, mais sa saturation et sa sensibilité en température.

Un sixième essai est réalisé pour déterminer l'évolution du champ magnétique engendré par la sonde 20 dans le plan du circuit imprimé 3. Pour le sixième essai, le fil conducteur 50 présente deux spires 52. La sonde 20 comprend la tige ferromagnétique 70. Pour le sixième essai, la tige ferromagnétique 70 est en ferrite et a un diamètre égal à 200 $\mu$m.

La figure 20 représente une courbe C6 d'évolution de la composante Bz du champ magnétique, en unité arbitraire, engendré par la sonde 20 mesurée sur une ligne sur la face supérieure du circuit imprimé lorsque la sonde est quasiment au contact du circuit imprimé à quelques microns près. La largeur à mi-hauteur du champ magnétique est de 660 um. C'est-à-dire qu'à une distance de 330 um de l'axe D de la sonde 20, le champ magnétique a déjà chuté d'au moins 50 %. Le sixième essai met en évidence que l'étendue spatiale du champ magnétique produit par la sonde 20 est réduit. Ceci permet avantageusement de sonder de façon sélective une zone de faible dimension. En particulier, pour un circuit imprimé 3, on évite que plusieurs pistes adjacentes ne produisent simultanément des signaux acoustiques qui produiraient des interférences gênant la mesure.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. A titre d'exemple, les modes de réalisation de la sonde 20 décrits en relation avec les figures 4 et 6 comprenant le support 83 peuvent être mis en oeuvre avec le mode de réalisation du guide 40 décrit en relation avec les figures 7 et 8.

Enfin, la mise en oeuvre pratique des modes de réalisation et variantes décrits est à la portée de la personne du métier à partir des indications fonctionnelles données ci-dessus.

**Revendications**

1. Système (10 ; 100) de mesure d'un courant électrique (I) circulant dans un élément conducteur électriquement (2), le système comprenant :

   - un dispositif (15) de génération d'un champ magnétique dans l'élément conducteur électriquement (2), comprenant un support (53) et un fil conducteur électriquement (50) rigidement couplé au support (53) et comprenant au moins une spire (52) enroulée autour du support (53) ;
   - un dispositif de détection (60) d'ondes acoustiques à la surface de l'élément conducteur électriquement (2) ; et
   - un dispositif de commande et d'acquisition (30) comprenant un générateur (33) configuré pour fournir au moins une impulsion de courant dans le fil conducteur électriquement (50) et une chaîne d'acquisition pour la détection d'un signal électrique (S) fourni par le dispositif de détection (60).

2. Système selon la revendication 1, comprenant en outre un guide d'ondes acoustique (40) ayant une base (41) et une extrémité effilée (42) fixée au support (53), et dans lequel le dispositif de détection (60) est un transducteur électroacoustique (60) rigidement couplé à la base (41).

3. Système selon la revendication 1, dans lequel le dispositif de détection (60) comprend un capteur de vibrations sans contact.

4. Système selon la revendication 3, dans lequel le dispositif de détection (60) comprend un vibromètre laser.

5. Système selon l'une quelconque des revendications 1 à 4, dans lequel le support (53) correspond à une tige ferromagnétique (70), les spires (52) étant enroulées autour de la tige ferromagnétique (70).

6. Système selon l'une quelconque des revendications 1 à 5, dans lequel le dispositif (15) de génération d'un champ magnétique comprend un aimant permanent (75).

7. Système selon l'une quelconque des revendications 1 à 6, dans lequel le générateur (33) est configuré pour fournir l'impulsion de courant dans le fil conducteur électriquement (50) ayant une durée deux fois plus courte que la période correspondant à la fréquence de variation maximale du courant électrique (I) circulant dans l'élément conducteur électriquement (2).

8. Système selon l'une quelconque des revendications 1 à 7, dans lequel le dispositif (30) de commande et d'acquisition comprend un amplificateur (35) recevant le signal de mesure (S) dont le gain est programmable par paliers croissants, chaque palier correspondant à une plage de variation possible de l'amplitude du courant électrique (I) circulant dans l'élément conducteur électriquement (2).

9. Dispositif (20) de détection d'un courant électrique (I) circulant dans un élément conducteur électriquement (2) comprenant :

   - un dispositif (15) de génération d'un champ magnétique dans l'élément conducteur électriquement (2), comprenant un support (53) et un fil conducteur électriquement (50) rigidement couplé au support (53) et comprenant au moins une spire (52) enroulée autour du support (53) ;
   - un guide d'ondes acoustiques (40) ayant une base (41) et une extrémité effilée (42) fixée au support (53) ; et
   - un transducteur électroacoustique (60) rigidement couplé à la base (41).

10. Dispositif selon la revendication 9, comprenant d'une spire (52) à vingt spires (52), de préférence de deux spires (52) à six spires (52) .

**11.** Dispositif selon la revendication 9 ou 10, dans lequel le support (53) correspond à une tige ferromagnétique (70), les spires (52) étant enroulées autour de la tige ferromagnétique (70), et dans lequel la tige ferromagnétique (70) pénètre dans le guide d'ondes acoustiques (40) par l'extrémité effilée (42).

**12.** Dispositif selon la revendication 11, dans lequel l'extrémité (54) de la tige ferromagnétique (70) opposée au guide d'ondes acoustiques fuselé (40) est taillée en pointe.

**13.** Dispositif selon la revendication 11 ou 12, comprenant un aimant permanent (75) au contact de la tige ferromagnétique (70) logé dans le guide d'ondes acoustiques (40) .

**14.** Dispositif selon l'une quelconque des revendications 9 à 13, dans lequel le guide d'ondes acoustiques (40) s'étend selon un axe (D) de la base (41) vers l'extrémité effilée (42), la section droite du guide d'ondes acoustiques (40) diminuant depuis la base (41) jusqu'à l'extrémité effilée (42).

**15.** Dispositif selon l'une quelconque des revendications 9 à 14, dans lequel le transducteur électroacoustique (60) est un transducteur électroacoustique à ondes transversales.

**16.** Dispositif selon l'une quelconque des revendications 9 à 15, dans lequel le guide d'ondes acoustiques (40) a au moins en partie la forme d'un tronc de cône.

**17.** Dispositif selon la revendication 16, dans lequel le guide d'ondes acoustiques (40) a un angle au sommet inférieur à 15 °.

**18.** Dispositif selon l'une quelconque des revendications 9 à 17, dans lequel le guide d'ondes acoustiques (40) est en un matériau non magnétique.

**19.** Dispositif selon l'une quelconque des revendications 9 à 18, dans lequel la température de fusion du guide d'ondes acoustiques (40) et la température de fusion du fil conducteur électriquement (50) sont supérieures à 1000°C.

**20.** Dispositif selon l'une quelconque des revendications 9 à 19, dans lequel le guide d'ondes acoustique (40) comprend une portion (45) en forme de disque, ayant un axe (D), aminci au niveau dudit axe (D), le support (53) s'étendant selon ledit axe (D) et étant relié à ladite portion (45) au niveau dudit axe (D).

**21.** Dispositif selon la revendication 20, dans lequel le transducteur électroacoustique (60) comprend au moins demi-anneau piézoélectrique résonnant en épaisseur fixé au chant (48) de ladite portion (45).

Fig 1

Fig 2

Fig 3

Fig 4

Fig 5

Fig 6

Fig 7

Fig 8

Fig 9

Fig 10

Fig 11

Fig 12

Fig 13

Fig 14

Fig 15

Fig 16

Fig 17

Fig 18

Fig 19

Fig 20

Europäisches
Patentamt

European
Patent Office

Office européen
des brevets

# RAPPORT DE RECHERCHE EUROPEENNE

Numéro de la demande

EP 24 16 9976

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | EP 2 400 308 A1 (ABB TECHNOLOGY AG [CH]) 28 décembre 2011 (2011-12-28) * figures * * revendications * * alinéas [0014] - [0017] * ----- | 1-21 | INV. G01R15/26 |
| A | ISHIDO M: "ACOUSTIC-WAVE-BASED VOLTAGE SENSORS", SENSORS AND ACTUATORS A: PHYSICAL, ELSEVIER BV, NL, vol. A44, no. 3, 1 septembre 1994 (1994-09-01), pages 183-189, XP000483962, ISSN: 0924-4247, DOI: 10.1016/0924-4247(94)00803-5 * figures * * revendications * * le document en entier * ----- | 1-21 | |
| A | EP 1 406 094 A1 (BOSCH GMBH ROBERT [DE]) 7 avril 2004 (2004-04-07) * figures * * revendications * * alinéas [0022] - [0031] * ----- | 1-21 | DOMAINES TECHNIQUES RECHERCHES (IPC) G01R |
| A | US 6 269 700 B1 (NIKOLOVSKI JEAN-PIERRE [FR]) 7 août 2001 (2001-08-07) * figures * * revendications * * page 2, ligne 35 - page 4, ligne 11 * ----- | 1-21 | |
| A | EP 1 092 980 A1 (UNIV PONTIFICIA COMILLAS [ES]) 18 avril 2001 (2001-04-18) * figures * * revendications * * alinéas [0024] - [0032] * ----- | 1-21 | |

Le présent rapport a été établi pour toutes les revendications

| Lieu de la recherche | Date d'achèvement de la recherche | Examinateur |
|---|---|---|
| La Haye | 25 juillet 2024 | Moulara, Guilhem |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
............................................................
& : membre de la même famille, document correspondant

EPO FORM 1503 03.82 (P04C02)

27

## ANNEXE AU RAPPORT DE RECHERCHE EUROPEENNE
## RELATIF A LA DEMANDE DE BREVET EUROPEEN NO.

EP 24 16 9976

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

25-07-2024

| Document brevet cité au rapport de recherche | | Date de publication | Membre(s) de la famille de brevet(s) | | Date de publication |
|---|---|---|---|---|---|
| EP 2400308 | A1 | 28-12-2011 | EP | 2400308 A1 | 28-12-2011 |
| | | | WO | 2011154157 A1 | 15-12-2011 |
| EP 1406094 | A1 | 07-04-2004 | DE | 10240242 A1 | 11-03-2004 |
| | | | EP | 1406094 A1 | 07-04-2004 |
| US 6269700 | B1 | 07-08-2001 | EP | 0934505 A1 | 11-08-1999 |
| | | | FR | 2755225 A1 | 30-04-1998 |
| | | | US | 6269700 B1 | 07-08-2001 |
| | | | WO | 9819133 A1 | 07-05-1998 |
| EP 1092980 | A1 | 18-04-2001 | AT | E308759 T1 | 15-11-2005 |
| | | | CA | 2314485 A1 | 01-04-2001 |
| | | | CN | 1290861 A | 11-04-2001 |
| | | | DE | 60023627 T2 | 20-07-2006 |
| | | | DK | 1092980 T3 | 06-03-2006 |
| | | | EP | 1092980 A1 | 18-04-2001 |
| | | | ES | 2157834 A1 | 16-08-2001 |
| | | | JP | 2001116774 A | 27-04-2001 |

EPO FORM P0460

Pour tout renseignement concernant cette annexe : voir Journal Officiel de l'Office européen des brevets, No.12/82